# EUROPÄISCHE PATENTSCHRIFT

(11) **EP 3 501 037 B1**
(45) Veröffentlichungstag und Bekanntmachung des Hinweises auf die Patenterteilung: **29.01.2020**
(21) Anmeldenummer: 17783732.5
(22) Anmeldetag: 21.09.2017
(51) Int. Cl.: H01L 21/687, H01L 21/20, H01L 21/18, H01L 21/683, H01L 21/67, H01L 21/762, H01L 23/00

(54) **VORRICHTUNG UND VERFAHREN ZUM VERBINDEN VON SUBSTRATEN**
APPARATUS AND METHOD FOR SUBSTRATE BONDING
APPAREIL ET MÉTHODE POUR LIAISON DE SUBSTRATS

(43) Veröffentlichungstag der Anmeldung: 26.06.2019
(60) Teilanmeldung: 19215305.4
(73) Patentinhaber: EV Group E. Thallner GmbH, 4782 St. Florian (AT)
(72) Erfinder: ZINNER, Dominik, 4755 Zell an der Pram (AT); WAGENLEITNER, Thomas, 4971 Aurolzmünster (AT); SÜSS, Jürgen Markus, 4791 Rainbach b. Schärding (AT); PLACH, Thomas, 4782 St. Florian am Inn (AT); MALLINGER, Jürgen, 4973 Senftenbach (AT)
(74) Vertreter: Schweiger, Johannes
(86) Internationale Anmeldenummer: PCT/EP2017/073930
(87) Internationale Veröffentlichungsnummer: WO 2019/057286

(56) Entgegenhaltungen:
- JP-A- H0 766 093
- JP-A- 2013 258 377
- US-A- 5 273 553
- US-A1- 2015 214 082
- US-A1- 2015 357 226
- US-A1- 2016 009 070
- US-B2- 6 706 618

## Beschreibung

Die vorliegende Erfindung betrifft ein Verfahren zum Bonden eines ersten Substrats mit einem zweiten Substrat gemäß Anspruch 1 sowie eine korrespondierende Vorrichtung gemäß Anspruch 8.

Seit mehreren Jahren werden in der Halbleiterindustrie Substrate durch sogenannte Bondprozesse miteinander verbunden. Vor der Verbindung müssen diese Substrate möglichst genau zueinander ausgerichtet werden, wobei mittlerweile Abweichungen im Nanometerbereich eine Rolle spielen. Die Ausrichtung der Substrate erfolgt dabei meistens über Ausrichtungsmarken. Neben den Ausrichtungsmarken befinden sich noch andere, insbesondere funktionale Elemente, im weiteren auch als Strukturen bezeichnet, auf den Substraten, die während des Bondprozesses ebenfalls zueinander ausgerichtet sein müssen. Diese Ausrichtungsgenauigkeit zwischen den einzelnen funktionalen Elementen wird für die gesamte Substratoberfläche verlangt. Es ist daher beispielsweise nicht auseichend, wenn die Ausrichtungsgenauigkeit im Zentrum der Substrate sehr gut ist, zum Rand hin aber abnimmt.

Aufnahmeeinrichtungen (engl.: chucks) gibt es in unterschiedlichsten Ausführungen. Entscheidend für die Aufnahmeeinrichtung ist insbesondere eine ebene Aufnahmefläche beziehungsweise Halterungsfläche zur Halterung/Fixierung der Substrate, damit die Strukturen auf den Substraten über die gesamte Substratfläche korrekt ausgerichtet und kontaktiert werden können.

Im Stand der Technik existiert bereits eine Anlage, mit deren Hilfe man lokale Verzerrungen zumindest teilweise reduzieren kann. Es handelt sich dabei um eine lokale Entzerrung durch die Verwendung aktiver Steuerelemente gemäß WO2012/083978A1.

Des Weiteren existieren im Stand der Technik erste Lösungsansätze zur Korrektur von "run-out"-Fehlern. Die US20120077329A1 beschreibt eine Methode, um eine gewünschte Ausrichtungsgenauigkeit zwischen den funktionalen Einheiten zweier Substrate während und nach dem Bonden zu erhalten, indem das untere Substrat nicht fixiert wird. Dadurch ist das untere Substrat keinen Randbedingungen unterworfen und kann während des Bondvorganges frei an das obere Substrat bonden.

Der Ausrichtungsprozess (engl.: alignment) spielt beim Bonden von Substraten eine Schlüsselrolle. Eines der größten technischen Probleme beim Verbinden zweier Substrate stellt die Ausrichtungsgenauigkeit der funktionalen Einheiten zwischen den einzelnen Substraten dar. Obwohl die Substrate durch Ausrichtungsanlagen sehr genau zueinander ausgerichtet werden können, kann es auch während des Bondvorgangs zu Verzerrungen der Substrate kommen. Durch die während des Bondvorgangs entstehenden Verzerrungen werden die funktionalen Einheiten nicht notwendigerweise an allen Positionen korrekt zueinander ausgerichtet. Die Ausrichtungsungenauigkeit an einem bestimmten Punkt am Substrat kann ein Resultat einer Verzerrung, eines Skalierungsfehlers, eines Linsenfehlers (Vergrößerungs- beziehungsweise Verkleinerungsfehlers) etc. sein. In der Halbleiterindustrie werden alle Themenbereiche, die sich mit derartigen Problemen befassen unter dem Begriff "Overlay" subsumiert. Overlay bezeichnet die Überdeckungsgenauigkeit von Strukturen aus unterschiedlichen Fertigungsschritten.

Als "run-out" Fehler werden Overlay-Fehler bezeichnet, die vor allem durch eine Verzerrung mindestens eines Substrats während eines Bondvorgangs entstehen. Durch die Verzerrung mindestens eines Substrats werden auch die funktionalen Einheiten des ersten Substrats in Bezug auf die funktionalen Einheiten des zweiten Substrats verzerrt. Diese Verzerrungen stellen nicht nur beim Bonden von zwei strukturierten Substraten ein Problem dar, sondern können auch beim Bonden eines strukturierten Substrates mit einem weitgehend unstrukturierten Substrat zu erheblichen Problemen führen. Dies ist insbesondere dann der Fall, wenn nach dem Bonden weitere Prozessschritte, die eine sehr genaue Ausrichtung zum strukturierten Substrat benötigen, durchgeführt werden sollen.

Die entstehenden "run-out" Fehler werden in den meisten Fällen radialsymmetrisch um die Kontaktstelle stärker, nehmen daher von der Kontaktstelle zum Umfang zu. In den meisten Fällen handelt es sich um eine linear zunehmende Verstärkung der "run-out" Fehler. Unter speziellen Bedingungen können die "run-out" Fehler aber auch nichtlinear zunehmen.

Die JP H07 66093 A offenbart eine Vorrichtung zum Laminieren von Wafern, wobei in den Ausführungsformen gemäß Abbildung 11 und 12 Substrate mit Platten verformt werden.

Die US 2015/357226 A1 betrifft ein Verfahren zum Bonden von Substraten mit einer Schicht, die gemeinsam mit einem darauf aufgenommenen Substrat verformt wird.

Aufgabe der vorliegenden Erfindung ist es, eine Vorrichtung und ein Verfahren zum Bonden zweier Substrate vorzusehen, mit welchen die Bondgenauigkeit erhöht wird.

Die vorliegende Aufgabe wird mit den Merkmalen der nebengeordneten Ansprüche gelöst. Vorteilhafte Weiterbildungen der Erfindung sind in den Unteransprüchen angegeben. In den Rahmen der Erfindung fallen auch sämtliche Kombinationen aus zumindest zwei in der Beschreibung, in den Ansprüchen und/oder den Zeichnungen angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Der Erfindung liegt der Gedanke zugrunde, dass zwischen mindestens einem der Substrate und der korrespondierenden Aufnahmeeinrichtung eine Platte angeordnet wird, wobei das Substrat mit der Platte vor und/oder während des Bondens gegenüber der Aufnahmeeinrichtung gekrümmt wird. Eine, vorzugsweise ebene, Aufnahmefläche der Aufnahmeeinrichtung zur Aufnahme der Platte und des Substrats wird demnach insbesondere nicht verformt. Insbesondere dient die Aufnahmeeinrichtung der Verformung/Krümmung der Platte, wobei durch die Krümmung der Platte auch das auf der Platte fixierte Substrat gekrümmt wird.

Die Erfindung beschreibt insbesondere eine Methode und eine Vorrichtung zum verbesserten Bonden zweier Substrate. Insbesondere wird darunter eine Minimierung des "run-out"-Fehlers verstanden. Der Erfindung liegt dabei insbesondere der Gedanke zu Grunde, eine Platte zwischen dem Substrat und der Aufnahmeeinrichtung zu platzieren, die einerseits von der Aufnahmeeinrichtung fixiert werden kann und selbst in der Lage ist, das Substrat zu fixieren. Die Platte, vorzugsweise eine Keramikplatte, wird insbesondere von einer Aufnahmeeinrichtung fixiert, die in der Lage ist, die Fixierung lokal anzusteuern. Die Fixierungen (insbesondere bestehend aus Fixiermitteln/Fixierelementen) sind insbesondere in mehreren Zonen gruppiert. Vorzugsweise im Zentrum der Aufnahmeeinrichtung befindet sich eine Vorrichtung zum Verbiegen der, insbesondere nur teilweise fixierten, Platte. Die Vorrichtung zum Verbiegen wird als Krümmungselement bezeichnet. Das Krümmungselement ist insbesondere eine Düse, durch die ein Fluid, vorzugsweise ein Gas, austreten kann, um einen Überdruck zwischen der Platte und der Aufnahmeeinrichtung zu erzeugen, welcher die Platte und somit das auf der Platte fixierte Substrat krümmt. Indem die Platte vorzugsweise am Umfang mit der Aufnahmeeinrichtung per Vakuum fixiert wird, ergibt sich eine Krümmung der Platte. Die Platte hält das Substrat während des Bondvorgangs vorzugsweise fixiert und erzeugt damit ein System bestehend aus der Platte und dem Substrat. Das System und/oder die Platte verfügen über einen höheren Biegewiderstand als das Substrat alleine. Der erhöhte Biegewiderstand dieses Systems wirkt sich positiv auf die Minimierung des "run-out" Fehlers aus. Der Biegewiderstand wird durch das Biegewiderstandsmoment charakterisiert.

Ein Kern der Erfindung besteht insbesondere darin, zwischen mindestens einem der beiden Substrate und der Aufnahmeeinrichtung eine Platte zu positionieren, welche gekrümmt werden kann. Über einen Krümmungsmechanismus, insbesondere über Druckluft, wird die Platte, insbesondere im Zentrum oder vom Zentrum des Substrats oder der Platte aus, gekrümmt. Da die Biegung der beiden Substrate in einem gewissen Abstand erfolgt, wird der Abstand (engl.: gap) bei voranschreiten der Bondwelle vorzugsweise reduziert, um eine vollflächige Kontaktierung der Substrate zu ermöglichen. Ein Krümmungselement des Krümmungsmechanismus zur Bewirkung der Krümmung ist insbesondere innerhalb der Fixierung, vorzugsweise im Zentrum, angeordnet.

Insbesondere besteht dabei die Möglichkeit, die (unter dem Substrat angeordnete) Platte vollständig von der Aufnahmeeinrichtung zu lösen. Dazu wird die Fixierung, insbesondere das Haltevakuum, der Aufnahmeeinrichtung deaktiviert, während der Krümmungsmechanismus, insbesondere die Druckluft, aktiviert bleibt. Die untere Platte schwimmt somit, sofern Druckluft verwendet wird, in diesem Zustand auf einem Luftpolster und ermöglicht eine vollflächige Kontaktierung der Substrate. Mittels der Platte wird das Substrat fixiert und so seine Dicke und damit seine Biegesteifigkeit erhöht. Dabei wird insbesondere auch seine Flexibilität reduziert, so dass das Bondergebnis deutlich verbessert wird.

Wird die Platte vollkommen von der Aufnahmeeinrichtung losgelöst, wird die Fixierung des Substrats durch die Platte beziehungsweise an der Platte, insbesondere das Vakuum, vorzugsweise über eine Fixierelementverbindung aufrechterhalten, welche insbesondere dehn- bzw. streckbar ist. Die Fixierung des Substrats an der Platte kann dadurch unabhängig von der Steuerung und Fixierung der Platte an der Aufnahmeeinrichtung aufrechterhalten werden.

Ein wesentlicher Vorteil der Erfindung besteht somit insbesondere darin, dass unterschiedliche Fehler, insbesondere der "run-out" Fehler und die Restfehler (engl.: residuals) fast vollständig eliminiert werden können.

Neben dem "run-out" Fehler, der insbesondere auf Verzerrungen zurückzuführen ist, existieren noch Translationsfehler, Rotationsfehler und Restfehler. Translationsfehler basieren insbesondere auf einer ungewollten translatorischen Verschiebung, Rotationsfehler insbesondere auf einer ungewollten Rotation der Strukturen, auf Substratebene, zueinander. Unter den Restfehlern versteht man alle nicht den "run-out" Fehler und/oder Translationsfehlern und/oder Rotationsfehlern zurechenbaren Fehler. Die Summe aller Fehler wird im weiteren Verlauf als Overlay bezeichnet.

Translations- und/oder Rotationsfehler beruhen vorwiegend auf einer ungenauen Ausrichtung der beiden Substrate zueinander, bevor der Bondprozess beginnt. Daher wird die Ausrichtung der Substrate bestmöglich, vorzugsweise mit entsprechenden Ausrichtungsvorrichtungen (engl.: alignern), durchgeführt. Beispielhafte Ausrichtungsvorrichtungen werden in den Druckschriften US6214692B1, WO2014202106A1, WO2015082020A1 beschrieben, auf die insbesondere Bezug genommen wird. Die Ausrichtung erfolgt vorzugsweise anhand von Ausrichtungsmarken und/oder anhand der vorhandenen funktionalen Einheiten auf den Substraten. Die Ausrichtungsgenauigkeit ist insbesondere besser als 500 nm, vorzugsweise besser als 300 nm, noch bevorzugter besser als 150 nm, am bevorzugtesten besser als 100 nm, am allerbevorzugtesten besser als 20 nm.

Der "run-out" Fehler zwischen zwei Strukturen ist insbesondere kleiner als 500 nm, vorzugsweise kleiner als 300 nm, noch bevorzugter kleiner als 150 nm, am bevorzugtesten kleiner als 100 nm, am allerbevorzugtesten kleiner als 20 nm.

Die Restfehler sind insbesondere kleiner als 100 nm, vorzugsweise kleiner als 50, noch bevorzugter kleiner als 30 nm, am bevorzugtesten kleiner als 20nm, am allerbevorzugtesten kleiner als 10 nm.

Mit Hilfe der erfindungsgemäßen Vorrichtungen und Verfahren kann der Overlay auf weniger als 500 nm, vorzugsweise weniger als 300 nm, noch bevorzugter weniger als 150 nm, am bevorzugtesten auf weniger als 100 nm, am allerbevorzugtesten auf weniger als 50 nm reduziert werden.

Die erfindungsgemäße Vorrichtung ist in der Lage, mit Hilfe von Regelschleifen einen optimalen Bondvorgang durchzuführen.

Durch unterschiedliche Platten mit unterschiedlichen Dicken kann die Flexibilität, insbesondere über die Einstellung der Biegesteifigkeit, gezielt eingestellt werden. Insbesondere können mehrere derartige Platten existieren, die auf einfachste Art und Weise, schnell, effizient und kostengünstig ausgetauscht werden können. Somit ist zu jedem Zeitpunkt, insbesondere bei der Verwendung unterschiedlicher Substrate, eine Anpassung an das jeweilige Substrat möglich.

Obwohl nicht bevorzugt, ist die Stapelung mehrerer Platten übereinander erfindungsgemäß denkbar.

Mit anderen Worten liegt der Erfindung der Gedanke zugrunde, dass mindestens eines der beiden Substrate, vorzugsweise beide Substrate, zur Ausrichtung der Kontaktflächen, insbesondere vor und/oder während des Bondens, vorzugsweise beim Fusionsbonden, verformt werden und dass zwischen mindestens einem der beiden Substraten und der Aufnahmeeinrichtung eine Platte angeordnet wird, auf der das Substrat fixiert wird während die Platte selbst an der Aufnahmeeinrichtung fixiert wird.

Mit Verformung ist insbesondere ein von einem Ausgangszustand, insbesondere Ausgangsgeometrie, der Substrate abweichender Zustand gemeint.

Die Erfindung betrifft somit ein Verfahren und eine Vorrichtung, um den "run-out"-Fehler zwischen zwei gebondeten Substraten, insbesondere durch thermodynamische und/oder mechanische Kompensationsmechanismen, beim Bonden zu verringern oder ganz zu vermeiden. Des Weiteren behandelt die Erfindung einen entsprechenden Artikel, der mit der erfindungsgemäßen Vorrichtung und dem erfindungsgemäßen Verfahren hergestellt wird.

Erfindungsgemäß wird das Bonden nach einer Kontaktierung der Kontaktflächen der Substrate insbesondere durch Loslösen der oberen und/oder der unteren Platten, initiiert. Durch die erfindungsgemäße Verwendung mindestens einer Platte ist im Gegensatz zum Stand der Technik allerdings auch eine sehr genau steuerbare Loslösung möglich, da durch die Versteifung des Substrats durch die Platte der Biegewiderstand des Systems aus Substrat und Platte steigt. Erfindungsgemäß werden daher im weiteren Verlauf der Druckschrift auch Methoden zum Bonden beschrieben, welche auf einem gezielten und kontrollierten Bondvorgang beruhen, welcher auf ein spontanes Fallenlassen des oberen Substrats und/oder der oberen Platte mit dem darauf fixierten Substrat verzichten kann.

### Aufnahmeeinrichtung

Im weiteren Verlauf der Druckschrift wird zuerst die erfindungsgemäße Ausführungsform anhand einer Aufnahmeeinrichtung mit einer Platte und einem Substrat beschrieben. Erfindungsgemäß offenbart wird später auch eine Vorrichtung, die über zwei derartige Aufnahmeeinrichtungen verfügt. Dabei kann es sein, dass die erfindungsgemäße Platte nur auf einer der beiden Aufnahmeeinrichtungen oder auf beiden Aufnahmeeinrichtungen verwendet wird. Wird nur eine Platte verwendet, kann sich diese an der oberen, vorzugsweise aber an der unteren Aufnahmeeinrichtung befinden. Die bevorzugteste erfindungsgemäße Ausführungsform besteht darin, zwei erfindungsgemäße Platten, jeweils eine zwischen einem Substrat und der zugehörigen Aufnahmeeinrichtung, zu verwenden.

### Substrat

Das erste und/oder zweite Substrat ist mit Vorzug radialsymmetrisch. Obwohl das Substrat jeden beliebigen Durchmesser besitzen kann, ist der Substrat Durchmesser insbesondere 1 Zoll, 2 Zoll, 3 Zoll, 4 Zoll, 5 Zoll, 6 Zoll, 8 Zoll, 12, Zoll, 18 Zoll oder größer als 18 Zoll. Die Dicke des ersten und/oder zweiten Substrats liegt zwischen 1 µm und 2000 µm, mit Vorzug zwischen 10 µm und 1500 µm, mit größerem Vorzug zwischen 100 µm und 1000 µm. In besonderen Ausführungsformen kann ein Substrat auch eine rechteckige, oder zumindest von der kreisförmigen Gestalt abweichende Form besitzen. Unter einem Substrat wird im weiteren Verlauf insbesondere ein Wafer verstanden.

Bevorzugt weisen die Substrate annähernd identische Durchmesser D1 und D2 auf, die insbesondere um weniger als 5 mm, vorzugsweise weniger als 3 mm, noch bevorzugter weniger als 1 mm, voneinander abweichen.

### Platte

Ein weiterer, insbesondere eigenständiger, Aspekt besteht in der Ausgestaltung der Platte und deren Verwendung zwischen dem Substrat und der Aufnahmeeinrichtung. Insbesondere ist die Platte mit ihrer vom Substrat abgewandten Seite auf einem Krümmungsmittel beiziehungsweise einem Krümmungsänderungsmittel der Aufnahmeeinrichtung angeordnet. Somit wird das Substrat nicht direkt verformt, sondern die Verformung des Substrats erfolgt mittelbar durch die Verformung der Platte durch die Krümmungsänderungsmittel.

Die Platte ist vorzugsweise an der Aufnahmeeinrichtung fixiert/fixierbar.

Die Platte wird insbesondere überwiegend, vorzugsweise vollständig aus einer Keramik, vorzugsweise einer technischen Keramik, hergestellt. Die Platte kann beschichtet sein.

Die Platte weist insbesondere den gleichen Durchmesser auf wie das auf ihr fixierte/fixierbare Substrat.

Gemäß einer bevorzugten Ausführungsform der vorliegenden Erfindung weist die Platte einen größeren Radius wie das auf ihr zu fixierende Substrat auf. Indem die Platte einen größeren Durchmesser aufweist als das Substrat, kann die Platte in vorteilhafter Weise, insbesondere ausschließlich, in dem das Substrat überragenden Bereich an der Aufnahmeeinrichtung fixiert werden.

Insbesondere entspricht der Radius der Platte mindestens 1.01-mal, vorzugsweise mehr als 1.1-mal, noch bevorzugter mehr als 1.2-mal, am bevorzugtesten mehr als 1.3-mal, am allerbevorzugtesten mehr als 1.4-mal, dem Radius des zu fixierenden Substrats. Besonders bevorzugte Ausführungsformen der erfindungsgemäßen Platte weisen Durchmesser auf, die zwischen 10% und 20% größer sind als die Durchmesser der zu fixierenden Substrate. Durch eine Platte, deren Radius bedeutend größer ist als der Radius des zu fixierenden Substrats kann erfindungsgemäß vor allem eine konstante Krümmung am Substrat eingestellt werden, so dass das Substrat auf der Platte eine perfekte Hohlkugelschale bildet. Durch die Anwendung von, insbesondere ausschließlich in einem Umfangsbereich wirkenden, Fixierungen der Platte auf der Aufnahmeeinrichtung kann die Platte so stark peripher gekrümmt werden, dass die Krümmung am Substrat von dieser idealen, konstanten Krümmung abweicht.

Ein dünnes Substrat besitzt auf Grund der geringen Dicke einen sehr kleinen Biegewiderstand. Der geringe Biegewiderstand führt zu einer äußerst hohen Flexibilität, die eine gezielte Steuerung des Bondvorgangs erschwert. Dies hat den Nachteil, dass im Zentrum Fehler, insbesondere Gasblasen (engl.: voids), das Bondergebnis negativ beeinflussen können. Durch die zusätzliche Unterstützung der Substrate mit der Platte wird der geringe Biegewiderstand des Substrats irrelevant, da die Platte das auf ihr fixierte Substrat beim Bondvorgang unterstützt. Ein erfindungsgemäßer, insbesondere eigenständiger Aspekt besteht darin, ein System aus der Platte und einem Substrat auszubilden, welches einen höheren Biegewiderstand als das einzelne Substrat (ohne Platte) aufweist.

Die Platte kann insbesondere am Rand über Abstufungen verfügen. Die Abstufungen werden insbesondere in Richtung der Aufnahmevorrichtung hin abgetragen, sodass peripher ein Leerraum zwischen der Platte und der Aufnahmeeinrichtung besteht. Dieser Leerraum erlaubt eine optimalere Verformung der Platte im Randbereich und unterstützt damit die Verformung.

In einer speziellen erfindungsgemäßen Ausführungsform kann die erfindungsgemäße Platte auf mehreren Piezoelementen gelagert und fixiert werden. Durch diese Maßnahme kann die Platte lokal verformt werden.

### Platte - Material

Die Platte wird unter anderem durch Materialparameter wie Reinheit, Eigensteifigkeit, Ebenheit und Verformbarkeit charakterisiert. Die Platte liegt zwischen der Aufnahmeeinrichtung und dem auf ihr fixierten/fixierbaren Substrat. Sie wird einerseits dick genug ausgebildet, um nicht durch ungewollte äußere Einflüsse verformt zu werden und dem darauf liegenden Substrat genügend Stützkraft bieten zu können, und andererseits dünn genug sein, um durch eine gezielte wirkende Kraft (Druckluft, Vakuum, mechanischer, pneumatischer oder elektrischer Aktuator) gebogen zu werden. Die Platte kann in eine konvexe und/oder in eine konkave Form gebracht werden.

Insbesondere weist die Platte eine Hitzebeständigkeit von mehr als 500°C, vorzugsweise mehr als 750°C, noch bevorzugter mehr als 1000°C, auf.

Die Platte kann beschichtet werden. Die Platte und/oder deren Beschichtung bestehen insbesondere zumindest teilweise, vorzugsweise überwiegend aus einem oder mehreren der folgenden Materialien:
- Metall, insbesondere
   ∘ Cu, Ag, Au, Al, Fe, Ni, Co, Pt, W, Cr, Pb, Ti, Ta, Zn, Sn,
- Halbleiter, insbesondere
   ∘ Ge, Si, Alpha-Sn, Fullerene, B, Se, Te,
- Verbindungshalbleiter, insbesondere
   ∘ GaAs, GaN, InP, InxGa1-xN, InSb, InAs, GaSb, AlN, InN, GaP, BeTe, ZnO, CuInGaSe2, ZnS, ZnSe, ZnTe, CdS, CdSe, CdTe, Hg(1-x)Cd(x)Te, BeSe, HgS, AlxGal-xAs, GaS, GaSe, GaTe, InS, InSe, InTe, CuInSe2, CuInS2, CuInGaS2, SiC, SiGe;
- Einem Oxid, insbesondere von einem der oben genannten Materialien,
- Legierungen, insbesondere Stahl, vorzugsweise
   ∘ Edelstahl,
   ∘ Werkzeugstahl,
   ∘ Warmarbeitsstahl,
   ∘ Schnellarbeitsstahl,
- Kunststoffe, insbesondere
   ∘ thermoplastische Kunststoffe, vorzugsweise
      ▪ Polyetheretherketon (PEEK)
      ▪ Polytetrafluorethylen (PTFE)
      ▪ Polyimide
      ▪ Polyamide-Imide.
   ∘ Duroplaste,
   ∘ Elastometere,
- Keramik, insbesondere
   ∘ Aluminiumoxid Al2O3,
   ∘ Zirkonoxid ZrO2,
   ∘ Siliziumkarbide, insbesondere
      ▪ reaktionsgebundenes siliziumfiltriertes Siliziumkarbid SiSiC,
      ▪ Siliziumkarbid SiC,
      ▪ Siliziumnitrid Si3N4,
      ▪ Oxynitridgebundenes Siliziumkarbid NSiC,
      ▪ gesintertes Siliziumkarbid SSiC,
- Glas.

In einer bevorzugten Ausführungsform ist die Platte eine Keramikplatte. Bevorzugt wurde die Platte aus einer speziellen Oxidkeramik, insbesondere Aluminiumoxid Al₂O₃, gefertigt.

Gemäß einer besonderen Ausführungsform besteht die Platte aus einer hochfesten, elastisch verformbaren Membran. Speziell kann die elastische Membran aus einem Folienmaterial bestehen.

### Platte - Krümmungsradius

Ein Krümmungsradius der ersten und/oder zweiten Platte beim Bonden, insbesondere beim Start des Bondens, ist insbesondere größer als 0.01 m, mit Vorzug größer als 0.1 m, mit größerem Vorzug größer als 1 m, mit noch größerem Vorzug größer als 10 m, mit allergrößtem Vorzug größer als 100 m, am bevorzugtesten größer als 1000 m.

In einer bevorzugten Ausführungsform ist der Krümmungsradius der ersten/unteren Platte gleich groß wie der Krümmungsradius der zweiten/oberen Platte. Dadurch kommt es zu einer bezüglich der Geometrie symmetrischen Ausgangsstellung für das Bonden.

In einer bevorzugten Ausführungsform ist der Krümmungsradius der Platte einstellbar. Durch die kontrollierte Krümmung der Platten ist es erfindungsgemäß bevorzugt, wenn dadurch der Krümmungsradius beider Substrate insbesondere an der Bondfront, um weniger als 5% voneinander abweicht, noch bevorzugter gleich ist.

### Platte - Dicke

Die Dicke der verformbaren Platte liegt insbesondere zwischen 0.1 und 10 mm, mit Vorzug zwischen 0.25 und 8 mm, mit größerem Vorzug zwischen 0.5 und 6 mm, am bevorzugtesten zwischen 1 und 5 mm.

### Platte - E-Modul

Der Elastizitätsmodul (E-Modul) ist ein Materialkennwert, der den Zusammenhang zwischen Dehnung und Spannung bei der Verformung eines festen Körpers bei einem linear-elastischen Verhalten beschreibt. Der E-Modul der Platte liegt zwischen 0.01 GPa und 1100 GPa, vorzugsweise zwischen 0.1 GPa und 800 GPa, noch bevorzugter zwischen 1 GPa und 600 GPa, am bevorzugtesten zwischen 10 GPa und 500 GPa, am allerbevorzugtesten zwischen 100 GPa und 450 GPa.

Die Platte weist insbesondere einen höheren E-Modul als das Substrat auf.

Die Platte weist eine ausreichende Eigensteifigkeit auf, um eine problemlose Handhabung zu gewährleisten sowie um optimale Stützeigenschaften für die Substrate zu bieten.

### Platte - Rauheit

Die Rauheit der Platte wird entweder als mittlere Rauheit, quadratische Rauheit oder als gemittelte Rauhtiefe angegeben. Die ermittelten Werte für die mittlere Rauheit, die quadratische Rauheit und die gemittelte Rauhtiefe unterscheiden sich im Allgemeinen für dieselbe Messstrecke bzw. Messfläche, liegen aber im gleichen Größenordnungsbereich. Daher sind die folgenden Zahlenwertebereiche für die Rauheit entweder als Werte für die mittlere Rauheit, die quadratische Rauheit oder für die gemittelte Rauhtiefe zu verstehen. Die Rauheit ist dabei kleiner als 100 µm, vorzugsweise kleiner als 10 µm, noch bevorzugter kleiner als 1 µm, am bevorzugtesten kleiner als 100nm, am allerbevorzugtesten kleiner als 10nm.

### Aufnahmeeinrichtung - Krümmungselement

Eine weitere, insbesondere eigenständige oder mit der vorgenannten kombinierbare, erfindungsgemäße Idee besteht in der Verwendung eines Verformelements als Krümmungsmittel und/oder Krümmungsänderungsmittel.

Die Platten und/oder die Substrate werden gekrümmt. Unter der Krümmung versteht man den Reziprokwert des Krümmungsradius eines Kreises (zweidimensional) beziehungsweise einer Kugel (dreidimensional) an den Schmiegepunkt, in dem die Krümmung bestimmt werden soll. Die Krümmung einer Platte und/oder eines Substrates kann daher insbesondere positionsabhängig sein. Vorzugsweise ist die Krümmung aber für alle Punkte auf einem Kreis um das Zentrum des Substrats konstant.

Anstatt der Krümmung wird vorzugsweise von der Biegung gesprochen. Unter der Biegung wird im gesamten Dokument der Abstand vom Zentrum der abgehobenen Oberfläche eines Objektes in Bezug zur Oberfläche des fixierenden Objektes verstanden. Im Speziellen versteht man daher unter der Biegung den Abstand im Zentrum zwischen der Oberfläche der Platte die in Richtung der Aufnahmeeinrichtung zeigt und der Oberfläche der Aufnahmeeinrichtung. Die Biegung ist/wird insbesondere kleiner als 1 mm, vorzugsweise kleiner als 500 µm, noch bevorzugter kleiner als 100 µm, am bevorzugtesten kleiner als 50 µm, am allerbevorzugtesten kleiner als 10 µm eingestellt.

Im Ausgangszustand sind die Substrate, insbesondere an einer Kontaktfläche, eben, abgesehen von etwaigen die Kontaktfläche überragenden Strukturen (Mikrochips, funktionale Bauteile) und Substrattoleranzen wie Biegung und/oder Dickenschwankungen. Die Substrate besitzen im Ausgangszustand maximal eine sehr leichte Biegung. Für einen 300 mm-Wafer sind Biegungen von weniger als 50 µm bevorzugt.

In einer ersten erfindungsgemäßen Ausführungsform handelt es sich bei dem Krümmungselement um eine Gasaustrittsöffnung. Die Gasaustrittsöffnung kann insbesondere eine Düse (oder mehrere) sein. Die Platte kann durch einen Gasstrom, der insbesondere für einen Überdruck sorgt, gekrümmt werden. Da die Platte, insbesondere am gesamten Umfang, mit der Aufnahmeeinrichtung per Vakuum fixiert wird, ergibt sich eine Krümmung/Biegung der Platte.

In einer zweiten erfindungsgemäßen Ausführungsform handelt es sich bei dem Krümmungselement um eine Piezovorrichtung, insbesondere eine Piezosäule.

In einer dritten erfindungsgemäßen Ausführungsform handelt es sich bei dem Krümmungselement um ein translatorisch bewegbares, steifes Objekt, insbesondere einen Stift (engl.: pin). Der Stift kann insbesondere durch hydraulische und/oder pneumatische und/oder Piezoelemente verstellt werden. Denkbar ist auch, dass sich in dem Stift eine Düse befindet, sodass man ein kombiniertes Krümmungselement erhält.

In einer vierten erfindungsgemäßen Ausführungsform handelt es sich bei dem Krümmungselement um eine oder mehrere Elektroden. Um das Substrat mittels Elektroden krümmen zu können, werden entweder geladene Materialien am Substrat angeordnet (technisch nichtbevorzugt) oder es werden influierbare Ladungen am Substrat vorgesehen.

In einer fünften erfindungsgemäßen Ausführungsform handelt es sich bei dem Krümmungselement um eine oder mehrere elektrische Spulen. Um das Substrat mittels Spulen krümmen zu können, weist das Substrat entweder magnetische Materialien auf oder es induzierbare Magnetfelder am Substrat ausgebildet.

Das Krümmungselement ist insbesondere in der Aufnahmeeinrichtung, vorzugsweise zentrisch, integriert. Die Krümmungselemente sind insbesondere steuer- und/oder regelbar.

Insbesondere, aber nicht bevorzugt, können mehrere Krümmungselemente vorgesehen werden, die die Platte oder das Substrat an unterschiedlichen Stellen verformen können.

Ein erfindungsgemäß charakteristischer Vorgang beim Bonden, insbesondere beim Permanentbonden, vorzugsweise Fusionsbonden, ist die möglichst zentrische, punktförmige Kontaktierung der beiden Substrate. Alternativ kann die Kontaktierung der beiden Substrate auch nicht zentrisch erfolgen. Die Distanz zwischen einem möglichen nicht-zentrischen Kontaktierungspunkt und dem Zentrum des Substrats ist insbesondere kleiner als 100 mm, mit Vorzug kleiner als 10 mm, mit größerem Vorzug kleiner als 1 mm, mit größtem Vorzug kleiner als 0.1 mm, mit allergrößtem Vorzug kleiner als 0.01 mm.

Bevorzugt wird mit Kontaktierung eine zentrische Kontaktierung beschrieben. Unter Zentrum wird mit Vorzug der geometrische Mittelpunkt eines zugrundeliegenden, wenn nötig um Asymmetrien kompensierten, idealen Körpers verstanden. Bei industrieüblichen Wafern mit einer Kerbe (engl.: notch) ist das Zentrum also der Kreismittelpunkt des Kreises, der den idealen Wafer ohne Kerbe, umgibt. Bei industrieüblichen Wafern mit einer abgeflachten Seite (engl.: flat) ist das Zentrum der Kreismittelpunkt des Kreises, der den idealen Wafer ohne Flat, umgibt. Analoge Überlegungen gelten für beliebig geformte Substrate. Alternativ wird unter dem Zentrum den Schwerpunkt des Substrats verstanden, soweit dies explizit beansprucht/beschrieben wird oder die obige Definition ersetzt.

Erfindungsgemäß kann nur eine der Platten und/oder eines der Substrate, mit Vorzug die untere Platte und/oder das untere Substrat, verformt werden. In diesem Fall wird das andere Substrat, mit Vorzug das obere Substrat mittels einer oberen Platte, insbesondere auf Grund der Gravitation automatisch mit dem verformten Substrat kontaktiert. Vorzugsweise weist das obere Substrat eine, insbesondere ausschließlich durch Gravitation bewirkte, Krümmung in Richtung des unteren Substrats auf.

### Platte und/oder Aufnahmeeinrichtung - Krümmungsmessmittel

Gemäß einer vorteilhaften Ausgestaltung der Erfindung weisen die Platte und/oder die Aufnahmeeinrichtung Krümmungsmessmittel zur Messung der Krümmung auf.

Die Platte und/oder die Aufnahmeeinrichtung können alternativ oder zusätzlich über Sensoren verfügen, mit deren Hilfe physikalische und/oder chemische Eigenschaften zwischen dem fixierten Substrat und der Platte und/oder zwischen der Platte und der Aufnahmeeinrichtung gemessen werden können. Bei den Sensoren handelt es sich vorzugsweise um:
- Temperatursensoren und/oder
- Drucksensoren und/oder
- Abstandssensoren.

Denkbar ist auch, dass mehrere unterschiedliche Sensorarten verbaut werden. In einer besonders bevorzugten Ausführungsform werden Sensoren zur Abstands- und Druckvermessung, insbesondere symmetrisch und gleichverteilt, in der Platte und/oder der Aufnahmeeinrichtung verbaut. Dadurch ist eine diskrete, aber flächendeckende Abstandsvermessung und Druckvermessung möglich. Die Druckvermessung ist von besonderem Vorteil, wenn es sich bei dem Krümmungselement um ein über einen Kanal eingebrachtes Fluid, insbesondere Gas- oder Gasgemisch handelt.

Die Daten der Krümmungsmessmittel und Sensoren werden insbesondere zur Steuerung/Regelung verwendet.

### Platte und/oder Aufnahmeeinrichtung - Heizelemente

In einer weiteren, erfindungsgemäßen Ausführungsform werden die Platte und/oder die Aufnahmeeinrichtung so ausgebildet, dass das Substrat und/oder die Platte, insbesondere abschnittsweise, temperiert werden können. Durch die Temperierung ist insbesondere eine gezielte zusätzliche Verformung des Substrats und/oder der Platte möglich. Sind die thermischen Ausdehnungskoeffizienten der Substrate und der Platte beziehungsweise der Platte und der Aufnahmeeinrichtung unterschiedlich, folgen die Substrate insbesondere der thermischen Dehnung der Platte beziehungsweise folgt die Platte insbesondere der thermischen Dehnung der Aufnahmeeinrichtung. Vorzugsweise werden das Substrat und/oder die Platte vor der Fixierung an der Platte beziehungsweise an der Aufnahmeeinrichtung durch Heiz- und/oder Kühlmittel vortemperiert beziehungsweise auf die gewünschte Temperatur gebracht.

Die Aufnahmeeinrichtung und/oder die Platte können in einem Temperaturbereich zwischen -100°C und 500°C, vorzugsweise zwischen -50°C und 450°C, noch bevorzugter zwischen -25°C und 400°C, am bevorzugtesten zwischen 0°C und 350°C temperiert werden.

**Platte und/oder Aufnahmeeinrichtung** - **Fixierungen und Fixierelemente** Erfindungsgemäß sind Plattenfixierungen vorgesehen, mit welchen das Substrat an der Platte fixiert oder fixierbar ist. Weiterhin sind Aufnahmeeinrichtungsfixierungen vorgesehen, mit welchen das Substrat, insbesondere vermittels der Platte, an der Aufnahmeeinrichtung fixiert oder fixierbar ist. Beide Fixierungen sind wesens- und gattungsgleich und werden daher nur einmal beschrieben. Auch der Aufbau, die Gruppierung und Zonenbildung der genannten Fixierungen kann für die erfindungsgemäße Platte und der Aufnahmeeinrichtung identisch sein. Denkbar ist allerdings auch, dass sie unterschiedlich ausgebildet sind.

Die Fixierung des Substrats an der Platte beziehungsweise der Platte an der Aufnahmeeinrichtung erfolgt bevorzugt in einem Außenbereich des Substrats, bevorzugt an einem, insbesondere das Substrat überragenden, Bereich der Platte.

Mit Vorzug wird das Substrat beziehungsweise die Platte ausschließlich an einem möglichst weit außenliegenden Kreissegment im Bereich des Seitenrandes fixiert, um dem Substrat beziehungsweise der Platte zum Zentrum hin die bestmögliche Flexibilität und Dehnungsfreiheit innerhalb der Fixierung zu gewähren.

Eine Fixierung besteht vorzugsweise aus mehreren Fixierelementen. Die Fixierelemente können insbesondere in Zonen gruppiert sein. Eine Gruppierung der Fixierelemente in Zonen erfüllt entweder eine geometrische, optische vorzugsweise aber eine funktionelle Aufgabe. Unter einer funktionellen Aufgabe ist beispielsweise zu verstehen, dass alle Fixierelemente einer Zone gleichzeitig geschaltet werden können. Denkbar ist auch, dass alle Fixierelemente in einer Zone individuell geschalten werden können. So können mehrere Fixierelemente gleichzeitig zur Fixierung beziehungsweise zum Lösen des Substrats bzw. der Platte innerhalb der Zone angesteuert werden oder sie können zwar individuell angesteuert werden, erzeugen aber in ihrer Zone eine sehr individuelle Verformungseigenschaft des Substrats bzw. der Platte.

Die Zonen können insbesondere folgende Geometrien annehmen:
- Einflächig,
- Kreissegment,
- Gekachelt, insbesondere als Dreieck, Viereck oder Sechseck.

Insbesondere können sich zwischen den Zonen auch Flächen ohne Fixierelemente befinden. Der Abstand zwischen solchen Zonen ist insbesondere kleiner als 50 mm, vorzugsweise kleiner als 25 mm, noch bevorzugter kleiner als 20 mm, am bevorzugtesten kleiner als 10 mm, am allerbevorzugtesten kleiner als 5mm. Sind die Zonen als Kreissegmente ausgelegt, dann wäre der Abstand die Distanz zwischen dem inneren Kreisring eines äußeren Kreissegments und dem äußeren Kreisring eines inneren Kreissegments.

Die Anzahl der Fixierelemente pro Zone ist beliebig. Insbesondere befinden sich in einer Zone mindestens 1 Fixierelement, vorzugsweise mindestens 2 Fixierelemente, vorzugsweise mehr als 10, bevorzugter mehr als 50, noch bevorzugtesten mehr als 100, am bevorzugtesten mehr als 200, am allerbevorzugtesten mehr als 500.

Gemäß einer vorteilhaften Ausführungsform der Erfindung weist die erste Aufnahmeeinrichtung und/oder die zweite Aufnahmeeinrichtung, insbesondere ringförmig, vorzugsweise kreisringförmig, am Umfang von Aufnahmeflächen der ersten Aufnahmeeinrichtung und/oder der zweiten Aufnahmeeinrichtung zur Aufnahme der Platten, insbesondere ausschließlich im Bereich von Seitenrändern der Platten/Substrate, angeordnete Fixiermittel auf.

Die Fixiermittel sind als, insbesondere gleichmäßig an den Aufnahmeflächen verteilt, vorzugsweise konzentrisch, angeordnete, in Zonen gegliederte, insbesondere separat steuerbare, Fixierelemente ausgebildet. Vorzugsweise sind die Fixiermittel, insbesondere ausschließlich, in einem Randbereich der Aufnahmefläche angeordnet. Der Randbereich erstreckt sich insbesondere bis zum halben Radius, vorzugsweise bis zu einem Viertel des Radius, der Aufnahmefläche.

Bei einer radialsymmetrischen Anordnung der Fixierelemente in einer Zone, können auch die Anzahl der Fixierelemente pro Querschnitt betrachtet werden. Die Anzahl der Fixierelemente im Querschnitt ist dabei kleiner als 20, vorzugsweise kleiner als 10, noch bevorzugter kleiner als 5, am bevorzugtesten kleiner als 3, am allerbevorzugtesten 1.

Die Fixierelemente, welche mit Unterdruck zur Fixierung beaufschlagbar sind, können zum Loslösen des Substrats auch mit Überdruck beaufschlagt werden.

In einer ersten erfindungsgemäßen Ausführungsform bestehen die Fixierelemente aus einfachen, insbesondere durch Bohrung oder Funkenerosion erzeugten, Löchern. In einer speziellen Ausführungsform sind die Fixierelemente ringförmige, insbesondere kreisringförmig, insbesondere durch einen Fräsprozess erzeugte, Schlitze. In Weiterbildung können die Fixierelemente mit Vakuumlippen versehen werden. Sind die Fixierelemente als Vakuumelemente vorgesehen, so können Sie einen Druck von weniger als 1bar, vorzugsweise weniger als 0,1 mbar, noch bevorzugter 0,01 mbar, am bevorzugtesten weniger als 0,001 mbar, am allerbevorzugtesten weniger als 0,0001 mbar erzeugen.

In einer zweiten erfindungsgemäßen Ausführungsform bestehen die Fixierelemente aus leitfähigen Platten, die als elektrostatische Fixierung verwendet werden. Die leitfähigen Platten können unipolar, vorzugsweise aber bipolar geschaltet werden. Bei einer bipolaren Schaltung werden zwei Platten auf wechselseitiges Potential gelegt. Die erfindungsgemäße Aufnahmeeinrichtung wirkt dann, insbesondere in Zonen, als elektrostatische Aufnahmeeinrichtung mit einer, abhängig von der Anzahl der Platten, hochaufgelösten elektrostatischen Fixiereigenschaft.

Je größer die Anzahl der Fixierelemente pro Einheitsfläche, desto besser die Steuerung der Fixiereigenschaft der Aufnahmeeinrichtung für das Substrat.

Mit Vorteil werden die erste Aufnahmefläche und/oder die zweite Aufnahmefläche aus, insbesondere eine erste Aufnahmeebene der ersten Aufnahmefläche und eine zweite Aufnahmeebene der zweiten Aufnahmefläche bildenden, Erhebungen gebildet.

Gemäß zwei weiteren Ausführungsformen werden die Aufnahmeeinrichtung und/oder die Platte mit Erhebungen, insbesondere Noppenaufnahmeeinrichtung bzw. Noppenplatte, beschrieben. Unter einer solchen Aufnahmeeinrichtung bzw. Platte versteht man eine Aufnahmeeinrichtung bzw. Platte, die über mehrere, insbesondere symmetrisch angeordnete, Stützen (engl.: pillars) verfügt. Diese Stützen werden insbesondere als Noppen ausgeführt. Die Noppen können beliebige Formen besitzen. Insbesondere vorgesehen sind Noppen in der Form von:
- Pyramiden, insbesondere dreiseitigen oder vierseitigen Pyramiden,
- Zylindern, insbesondere mit flachem oder abgerundetem Kopf,
- Quadern,
- Kegeln,
- Kugelschalen.

Kugelschalennoppen, Kegelnoppen und Zylindernoppen sind aufwendig herzustellen, wohingegen pyramidenförmige oder quaderförmige Noppen durch Ätz- und/oder Fräsprozesse relativ einfach gefertigt werden können und somit erfindungsgemäß bevorzugt sind.

Die genannten Noppenaufnahmeeinrichtungen bzw. Noppenplatten können an ihrer Peripherie über ein Randelement abgeschlossen sein, sodass die Raumbereiche zwischen den Noppen als Vertiefungen interpretiert werden können. Möglich ist aber auch, dass die Noppen die einzigen Erhöhungen in Bezug zur Noppenebene darstellen, auf denen alle Noppen vorhanden sind.

In einer dritten bevorzugten erfindungsgemäßen Ausführungsform wird die Aufnahmeeinrichtung als Noppenaufnahmeeinrichtung und/oder die Platte als Noppenplatte mit Stegen ausgeführt. Die einzelnen Zonen werden hierbei durch Stege unterbrochen. Innerhalb einer jeden Zone endet mindestens eine Leitung, die eine Evakuierung des Raumes zwischen den Noppen gestattet. Durch die Verwendung mehrerer, insbesondere individuell ansteuerbarer, Kanäle ist eine örtlich abhängige, unterschiedlich starke, Evakuierung des Raumes möglich.

In einer vierten, noch bevorzugteren Ausführungsform wird die Aufnahmeeinrichtung und/oder die Platte als vollständige Noppenaufnahmeeinrichtung bzw. Noppenplatte, also ohne Stege, ausgeführt.

Die Breite beziehungsweise der Durchmesser der Erhebungen, insbesondere Noppen, ist insbesondere kleiner als 5mm, vorzugsweise kleiner als 1mm, noch bevorzugter kleiner als 500µm, am bevorzugtesten kleiner als 200µm.

Die Höhe der Erhebungen, insbesondere Noppen, ist insbesondere kleiner als 2mm, vorzugsweise kleiner als 1 mm, noch bevorzugter kleiner als 500µm, am bevorzugtesten kleiner als 200µm.

Insbesondere ist das Verhältnis zwischen der Breite beziehungsweise dem Durchmesser der Erhebungen und der Höhe der Erhebungen größer als 0.01, vorzugsweise größer als 1, noch bevorzugter größer als 2, am bevorzugtesten größer als 10, am allerbevorzugtesten größer als 20.

Alle genannten erfindungsgemäßen Ausführungsformen können auch beliebig miteinander kombiniert werden. So ist es denkbar, dass eine erste Zone aus elektrostatisch arbeitenden Fixierelementen besteht, und eine zweite Zone Vakuumfixierungen besitzt.

Die erfindungsgemäße Aufnahmeeinrichtung und/oder Platte kann insbesondere über Löcher, im weiteren Verlauf der Druckschrift als Vermessungslöcher bezeichnet, verfügen, die eine Betrachtung der fixierten Substratoberfläche von der Rückseite der Aufnahmeeinrichtung und Platte zu erlauben. Dadurch wird eine Vermessung der fixierten Substratoberfläche in diesem Bereich ermöglicht. Die Vermessungslöcher können auch mittels eines Deckels verschlossen werden. In einer ganz besonders bevorzugten Ausführungsform lassen sich die Vermessungslöcher mit dem Deckel vollautomatisch öffnen oder schließen.

Eine erfindungsgemäße Aufnahmeeinrichtung kann alternativ oder zusätzlich über Sensoren verfügen, mit deren Hilfe physikalische und/oder chemische Eigenschaften zwischen dem fixierten Substrat und der Aufnahmeeinrichtung vermessen werden können. Bei den Sensoren handelt es sich vorzugsweise um
- Temperatursensoren und/oder
- Drucksensoren und/oder
- Abstandssensoren.

Die besonders bevorzugten Abstandssensoren sind als Krümmungsmessmittel einsetzbar, indem vom Abstand zwischen dem Substrat und der Aufnahmeeinrichtung bzw. vom Abstand zwischen der Platte und der Aufnahmeeinrichtung die Krümmung des Substrats bzw. der Platte ermittelt, insbesondere zwischen Stützstellen interpoliert und/oder berechnet, wird.

Erfindungsgemäß bevorzugt werden, insbesondere entlang der Aufnahmefläche verteilte, Abstandssensoren verwendet, um eine bessere Steuerung oder sogar Regelung der Verformungen, insbesondere Krümmung und/oder Krümmungsänderung, zu ermöglichen.

In einer besonders bevorzugten Ausführungsform sind mehrere Sensoren vor allem als Abstandssensoren ausgebildet, um den Abstand des Substrats bzw. der Platte vor und/oder während des Bondvorgangs in Bezug zu einer Ebene zu vermessen. Bei der Ebene handelt es sich vorzugsweise um die Aufnahmefläche und/oder die Aufnahmefläche, insbesondere eine durch die Erhebungen gebildete Ebene.

Denkbar ist auch, dass sich Sensoren auf unterschiedlichen Ebenen befinden. Vorzugsweise vermessen die Sensoren, insbesondere ausschließlich, die Veränderung eines Abstandes, vorzugsweise quer zur Kontaktfläche, sodass der Bezug auf eine und/oder mehrere Ebenen irrelevant ist. In diesem Fall muss nur die relative, insbesondere örtlich unterschiedliche, Abstandsänderung des Substrats bzw. der Platte erfasst werden.

Die Vermessung des Abstandes dient vor allem der Prozesssteuerung. Durch die Kenntnis des exakten Krümmungszustandes des Substrats bzw. der Platte, erfolgt die Ansteuerung/Regelung der erfindungsgemäßen Fixierelemente zur optimalen, insbesondere schrittweisen, Loslösung des Substrats bzw. der Platte besonders effizient.

Denkbar ist auch, dass mehrere unterschiedliche Sensorarten verbaut werden. In einer besonders bevorzugten Ausführungsform werden Sensoren zur Abstands- und Druckvermessung, insbesondere symmetrisch und gleichverteilt, in der Aufnahmeeinrichtung und/oder der Platte verbaut. Dadurch ist eine diskrete, aber flächendeckende Abstandsvermessung und Druckvermessung möglich. Die Druckvermessung ist von besonderem Vorteil, wenn es sich bei dem Verformungselement um ein über eine Leitung eingebrachtes Fluid, insbesondere Gas- oder Gasgemisch handelt.

Soweit eine oder beide Aufnahmeeinrichtungen ohne Krümmungsmessmittel und/oder ohne Sensoren ausgebildet sind, kann die Einstellung und/oder Steuerung der Krümmungen und/oder Krümmungsänderungen auf Basis empirisch ermittelter Parameter erfolgen.

Um eine exakte, insbesondere zentrische und punktförmige Kontaktierung zu gewährleisten wird in der Aufnahmeeinrichtung eine, insbesondere radialsymmetrische, Fixierung verwendet.

Die Anzahl der Fixierelemente der Platte während des Biegungsvorgangs wird vorzugsweise so gewählt, dass eine Biegung der Platte von 100µm erreicht werden kann, ohne dass sich diese von der Aufnahmeeinrichtung löst. Insbesondere werden neben den Vakuumbahnen noch andere Vakuumelemente verwendet, um einen Unterdruck zu erzeugen. Dazu zählen vor allem Dichtungselemente, insbesondere Dichtringe und Vakuumlippen.

Die Fixierung des Substrats bzw. der Platte auf der Aufnahmeeinrichtung ist vorzugsweise über die gesamte Fläche des Substrats bzw. der Platte möglich. Die Biegung des Substrats bzw. der Platte erfolgt in einer bevorzugten Ausführungsform im Zentrum der Aufnahmeeinrichtung über Druckluft.

Die Aufnahmeeinrichtung hat insbesondere eine Bohrung für die Zufuhr von Druckluft beziehungsweise für den Aktuator und Vakuumbahnen im Randbereich. Hier ist mindestens ein die Aufnahmefläche unterbrechender Unterdruckkanal in dem äußeren Ringabschnitt der Aufnahmekontur vorgesehen. Je nach Bedarf kann die Aufnahmefläche der Aufnahmeeinrichtungen reduziert werden, sodass sich eine kleinere Kontaktfläche zwischen dem Substrat bzw. der Platte und der Aufnahmeeinrichtung ergibt. Weitere Möglichkeiten der Fixierung der Aufnahmeeinrichtung und dem Substrat bzw. der Platte sind insbesondere
- mechanische Fixierung durch Klemmen und/oder
- elektrostatische Fixierung und/oder
- magnetische Fixierung und/oder
- GelPak-Fixierung

Bei der radialsymmetrischen Fixierung handelt es sich z.B. um Vakuumbahnen, angebrachte Vakuumlöcher, eine kreisrunde Vakuumlippe oder vergleichbare Vakuumelemente, mit deren Hilfe die Platte fixiert werden kann. Denkbar ist auch die Verwendung einer elektrostatischen Aufnahmeeinrichtung.

### Platte und/oder Aufnahmeeinrichtung - Noppenstruktur

Die Aufnahmeeinrichtung und/oder die Platte sind gemäß einer Ausführungsform mit einer Noppenstruktur versehen. Die Noppen stellen eine geringe, insbesondere gleichmäßig und stetig verteilte, Anzahl an Stützstellen für das Substrat und/oder die Platte dar. Dadurch wird eine mögliche Kontamination des Substrats und/oder der Platte verhindert, gleichzeitig aber die Stabilität aufrechterhalten. Entsprechende Noppenaufnahmeeinrichtungen werden in der WO2015113641A1 beschrieben auf die insofern Bezug genommen wird.

### Bonder

Im weiteren Verlauf der Druckschrift wird auf einen erfindungsgemäßen Bonder eingegangen, der aus zwei erfindungsgemäßen Aufnahmeeinrichtungen besteht, von denen mindestens einer eine erfindungsgemäße Platte aufweist.

Mit Vorzug werden in einer vertikalen Richtung und Position beide Substrate, insbesondere vollflächig, durch die jeweils zugeordnete Platte unterstützt. Gleichzeitig werden die Substrate, insbesondere symmetrisch zu einer Bondinitiierungsstelle (erster Kontaktpunkt zwischen den Substraten beim Beginn des Bondens), durch je ein Verformungsmittel zur Bondinitiierungsstelle hin gekrümmt, sodass die konvexen Oberflächen an der Bondinitiierungsstelle kontaktiert werden können. Der, insbesondere selbsttätige, Bondvorgang mit Bondwelle wird vorzugsweise durch Loslösen mindestens einer der Substrate und/oder Platten von der Aufnahmeeinrichtung gestartet.

Die erfindungsgemäßen Ausführungsformen, insbesondere der gesamte Bonder, werden mit Vorzug in einer definierten, insbesondere steuerbaren, Atmosphäre, bevorzugt unter Normaldruck, betrieben. Die erfindungsgemäße Vorrichtung kann vorteilhaft unter Inertgas betrieben werden. Eine bevorzugt vorhandene Gasatmosphäre kann den Kontaktier-Vorgang dämpfen und somit verhindern, dass die Kontaktflächen vorzeitig bzw. an mehreren Stellen gleichzeitig in Kontakt kommen. Durch diese Maßnahme werden Verzerrungen vermieden. Zur Steuerung des Bondens während dem Kontaktieren ist es insbesondere denkbar, den Druck im Bonder zu steuern.

### Verfahren - Bonden

Es ist erfindungsgemäß möglich, die Biegung der Platte und damit die Biegung des an der Platte fixierten Substrats im Bondverlauf exakt zu kontrollieren.

Ein, insbesondere eigenständiger, Erfindungsaspekt besteht darin, möglichst koordiniert und gleichzeitig quasi-selbsttätig zu kontaktieren, indem beide Substrate, oder zumindest eines der Substrate, mit einer, insbesondere konzentrisch zur Mitte M einer Kontaktfläche des Substrats radial nach außen verlaufenden, Vorspannung vor dem Kontaktieren beaufschlagt wird. Diese Vorspannung wird durch das Biegen der Platte, auf der das Substrat fixiert ist, gewährleistet. Dadurch wird dann nur der Beginn des Kontaktierens beeinflusst, während nach Kontaktierung eines Abschnitts, insbesondere der Mitte M des Substrats, das Substrat, noch immer an der Platte fixiert, freigelassen wird und somit selbsttätig, durch die Platte unterstützt, auf Grund seiner Vorspannung kontrolliert mit dem gegenüberliegenden Substrat bondet. Die Vorspannung wird durch eine steuerbare Verformung der Platte und somit indirekt eine steuerbare Verformung der Substrate mittels Verformungsmitteln erreicht, wobei die Verformungsmittel insbesondere auf die von der Bondseite abgewandte Seite einwirken.

Loslöse- und Druckbeaufschlagungsprozesse können vollflächig oder lokal oder entlang einer vorgegebenen Strecke wirken. Entsprechend werden die Krümmungselemente bzw. Fixierelemente geschaltet beziehungsweise gesteuert.

Die Biegung der beiden Substrate erfolgt insbesondere in einem gewissen Abstand, wobei dieser bei Voranschreiten der Bondwelle der Abstand reduziert wird. Insbesondere kann für eine vollflächige Kontaktierung der Substrate die Platte vollständig von der Aufnahmeeinrichtung gelöst werden. Das Substrat bleibt dabei an der Platte fixiert. Dazu fixieren die Fixierelemente der Aufnahmeeinrichtung deaktiviert während das Krümmungselement aktiviert wird bzw. aktiviert bleibt. Insbesondere bei der Verwendung eines Fluids, welches aus einer Düse austritt, schwimmt die untere Platte wie auf einem Luftpolster und ermöglicht eine vollflächige Kontaktierung der Substrate. Der Druck des Fluids wird durch Steuerungsmittel reguliert und angepasst, sodass der Prozess optimal verläuft.

Um zu verhindern, dass eine x-y-Ausrichtung der Substrate zueinander, insbesondere durch eine Verschiebung der Platte, geändert wird, kann die Platte zusätzlich von Begrenzungselementen in einer ausgerichteten x-y-Position gehalten werden. Die Begrenzungselemente können sich entweder außerhalb der Platte befinden und eine translatorische und/oder rotatorische Bewegung der Platte verhindern und/oder sie werden durch Bohrungen der Platte geführt um die Platte an einer Translation und/oder Rotation zu hindern. Da die erfindungsgemäßen Platten nur sehr geringe Biegungen aufweisen müssen, reicht ein Spiel von wenigen Mikrometern zwischen den Bohrungen der Platte und den Begrenzungselementen um eine reibungslose Biegung der Platte zu gewährleisten aber eine nennenswerte Verschiebung und/oder Rotation weitestgehend zu unterbinden.

Ein weiterer, insbesondere eigenständiger, erfindungsgemäßer Aspekt von Begrenzungselementen (oder alternativ separaten/zusätzlichen Auffangelementen) ist das mechanische Auffangen einer vollständig von der Fixierung der Aufnahmeeinrichtung gelösten Platte. Werden sämtliche Fixierungen einer oberen Aufnahmeeinrichtung abgeschaltet, so würde ohne derartige Begrenzungselemente eine obere Platte von der oberen Aufnahmeeinrichtung fallen. Die Begrenzungselemente verhindern das Fallen und halten die obere Platte in Position. Damit ist eine völlige Loslösung oder Entkopplung der Platte von der Aufnahmeeinrichtung möglich. Die Begrenzungselemente wirken insbesondere in z-Richtung begrenzend.

Die Anzahl der Begrenzungselemente liegt insbesondere zwischen 1 und 100, vorzugsweise zwischen 1 und 50, noch bevorzugter zwischen 1 und 25, am bevorzugtesten zwischen 1 und 10, am allerbevorzugtesten sind genau 3 Begrenzungselemente vorgesehen. Bei den Begrenzungselementen kann es sich beispielsweise um folgende Elemente handeln:
- Schrauben und/oder,
- Stifte und/oder,
- Anker und/oder,
- Bleche und/oder,
- speziell gefertigte Formelemente

Wird die obere Platte nach der erfolgten Kontaktierung an der Bondinitiierungsstelle beider Substrate vollständig von der Aufnahmeeinrichtung gelöst, fällt das obere Substrat, noch an der Platte fixiert, einerseits durch die Schwerkraft und andererseits bedingt durch eine entlang der Bondwelle und zwischen den Substraten wirkende Bondkraft, nach unten.

Das obere Substrat wird radial vom Zentrum beziehungsweise von der Bondinitiierungsstelle zum Seitenrand hin mit dem unteren Substrat verbunden. Es kommt so zu einer erfindungsgemäßen Ausbildung einer radialsymmetrischen Bondwelle, die insbesondere vom Zentrum zum Seitenrand verläuft. Während des Bondvorganges drücken die beiden Substrate das zwischen den Substraten vorliegende Gas, insbesondere Luft, vor der Bondwelle her und sorgen damit für eine Bondgrenzfläche ohne Gaseinschlüsse. Das obere Substrat, durch die Platte unterstützt, liegt während des Fallens praktisch auf einer Art Gaspolster.

Das erste/obere Substrat, unterstützt durch die Platte, unterliegt nach der Initiierung des Bonds an der Bondinitiierungsstelle keiner zusätzlichen Fixierung und kann sich somit - abgesehen von der Fixierung an der Bondinitiierungsstelle und der Fixierung an der Platte - frei bewegen und auch verzerren. Die Platte wird so gewählt, dass diese flexibel genug ist, um mit dem Substrat "run-out" Fehler beim Bonden zu minimieren und gleichzeitig die Substrate genügend zu unterstützen, um durch eine zu hohe Weichheit der Substrate bedingte Bondfehler zu vermeiden.

Nach Abschluss des Bondvorgangs ist der gebondete Substratstapel durch die obere und untere Platte geschützt und kann so entladen bzw. weiter transportiert werden. Alternativ wird z.B. nach Abschluss des Bondvorgangs das zweite/obere Substrat von der Platte gelöst. Der gebondete Substratstapel bleibt bis zum Entladevorgang zumindest auf der unteren Platte fixiert. Die untere Platte wird bei Bedarf ebenfalls wieder mit Vakuum an der Aufnahmeeinrichtung fixiert.

Die Aufnahmeeinrichtung kann gemäß einer vorteilhaften Ausführungsform über eine zweite Vakuumzone verfügen, um eine vollflächige Fixierung der Platte zu gewährleisten. Diese zweite Vakuumzone der Aufnahmeeinrichtung kann z.B. kreuzförmig, linienförmig oder kreisförmig ausgebildet sein. Die Aufnahmeeinrichtung hat somit insbesondere eine erste Vakuumzone mit Vakuumbahnen im Randbereich, bevorzugt in einer äußeren Kreisringfläche und eine zweite Vakuumzone im Innenbereich, bevorzugt in einer inneren Kreisfläche.

Durch den punktförmigen Kontakt im Zentrum läuft die Bondwelle beim erfindungsgemäßen Bonden vorzugsweise radialsymmetrisch vom Zentrum zum Seitenrand und drückt bei diesem Vorgang ein ringförmiges (konzentrisches) Gaspolster vor sich her. Entlang der, insbesondere näherungsweise kreisringförmigen, Bondfront der Bondwelle herrscht eine derart große Bondkraft vor, dass Einschlüsse von Gasblasen gar nicht erst entstehen können. Das obere/zweite Substrat liegt daher während des Bondvorgangs auf einer Art Gaspolster.

Vorzugsweise werden alle veränderbaren Parameter so gewählt, dass die Bondwelle sich mit einer möglichst optimalen Geschwindigkeit bezüglich der vorhandenen Anfangs- und Randbedingungen ausbreitet. Vor allem bei vorhandener Atmosphäre, insbesondere Normaldruck, ist eine möglichst langsame Geschwindigkeit der Bondwelle vorteilhaft. Die Geschwindigkeit der Ausbreitung der Bondwelle wird insbesondere so eingestellt, dass sie geringer als 200 cm/s, mit größerem Vorzug gering er als 100 cm/s, mit größerem Vorzug geringer als 50 cm/s, mit größtem Vorzug geringer als 10 cm/s, mit allergrößtem Vorzug geringer als 1 cm/s. Insbesondere ist die Geschwindigkeit der Bondwelle größer als 0,1 cm/s. Insbesondere ist die Geschwindigkeit der Bondwelle entlang der Bondfront konstant.

Alle erwähnten erfindungsgemäßen Ausführungsformen können in einer speziellen Ausführungsvariante im Vakuum, speziell im Niedervakuum oder im Hochvakuum durchgeführt werden. In einer Vakuumumgebung wird die Geschwindigkeit der Bondwelle automatisch schneller, da die sich entlang der Bondlinie verbindenden Substrate keinen Widerstand durch ein Gas überwinden müssen.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:
- Figur 1: eine erste erfindungsgemäße Ausführungsform mit Diagrammen zu Druck- und Durchbiegungsverläufen,
- Figur 2a: die erste Ausführungsform einer erfindungsgemäßen Vorrichtung in einem ersten Prozessschritt eines erfindungsgemäßen Verfahrens,
- Figur 2b: die erste Ausführungsform in einem zweiten Prozessschritt,
- Figur 2c: die erste Ausführungsform in einem dritten Prozessschritt,
- Figur 2d: die erste Ausführungsform in einem vierten Prozessschritt,
- Figur 2e: die erste Ausführungsform in einem fünften Prozessschritt,
- Figur 3: eine zweite Ausführungsform der erfindungsgemäßen Vorrichtung,
- Figur 4a: eine dritte Ausführungsform der erfindungsgemäßen Vorrichtung in einem ersten Prozessschritt und
- Figur 4b: die dritte Ausführungsform in einem zweiten Prozessschritt.

In den Figuren sind gleiche Bauteile oder Bauteile mit der gleichen Funktion mit den gleichen Bezugszeichen gekennzeichnet.

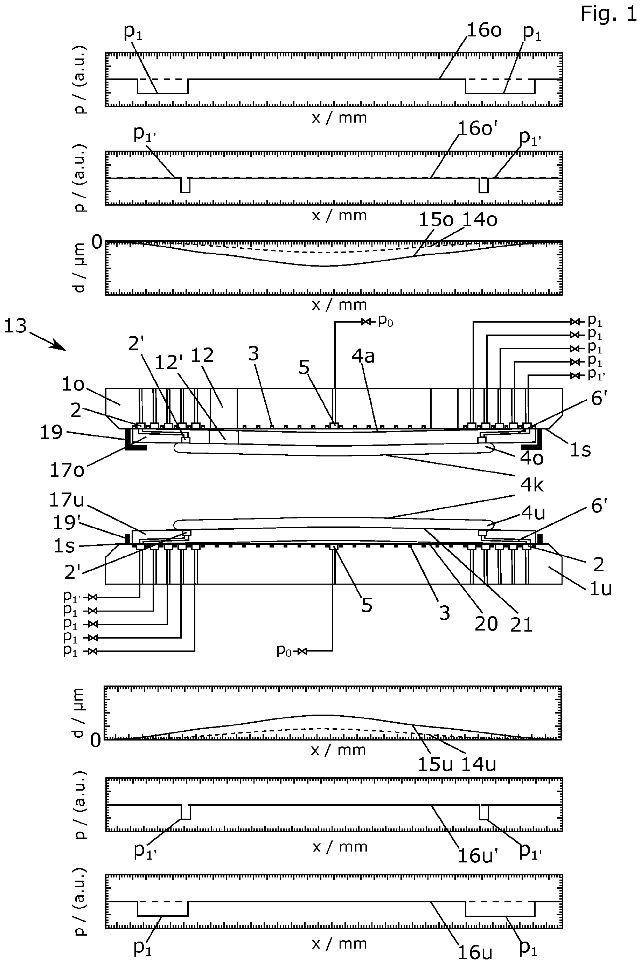

Die **Figur 1** zeigt einen erfindungsgemäßen Bonder 13 in einem erfindungsgemäßen Prozessschritt, wobei von dem Bonder 13 zur Veranschaulichung nur eine untere Aufnahmeeinrichtung 1u und eine der unteren Aufnahmeeinrichtung 1u gegenüberliegend angeordnete obere Aufnahmeeinrichtung 1o dargestellt sind. Die übrigen, üblichen Bestandteile des Bonders 13 sind nicht dargestellt.

Auf der unteren Aufnahmeeinrichtung 1u wird eine untere Platte 17u an einer ersten Plattenseite 20 mittels ringförmig verlaufenden ersten Fixierelementen 2 der unteren Aufnahmeeinrichtung 1u fixiert. Die Fixierelemente 2 sind insbesondere fluidtechnisch beaufschlagbar, vorzugsweise mit durch Druck beaufschlagbaren, die Aufnahmeeinrichtung 1u durchsetzenden Kanälen.

Die untere Platte 17u besitzt an einer der ersten Plattenseite 20 gegenüberliegenden Plattenseite 21 zweite Fixierelemente 2', die vorzugsweise direkt durch die untere Aufnahmeeinrichtung 1u angesteuert werden können und/oder mit den ersten Fixierelementen 2 verbunden sind. Ebenso weist die obere Aufnahmeeinrichtung 1o eine obere Platte 17o auf, die mittels ringförmig verlaufenden Fixierelementen 2 der oberen Aufnahmeeinrichtung 1o fixierbar ist.

Bei allen gezeigten Ausführungsformen werden die zweiten Fixierelemente 2' der Platten 17u, 17o über Fixierelementverbindungen 6' mit der Aufnahmeeinrichtung 1o, 1u verbunden. Handelt es sich bei den Fixierelementen 2, 2' um Vakuumfixierungen, sind die Fixierelementverbindungen 6' vorzugsweise als, insbesondere die Platten 17u, 17o durchsetzende, Kanäle ausgebildet. Bei Evakuierung der Kanäle der unteren Aufnahmeeinrichtung 1u werden, insbesondere automatisch, auch die Fixierelementverbindungen 6' der unteren Platte 17u evakuiert. Das gleiche gilt für die obere Platte 17o und die obere Aufnahmeeinrichtung 1o.

Die Platten 17u, 17o befinden sich in einem gekrümmten Zustand, weil innerhalb der ringförmig verlaufenden Fixierelemente 2 Krümmungselemente 5 eine Krümmung bewirken, während die Fixierelemente 2 die Platten 17u, 17o fixieren.

Ein erstes (oberes) Substrat 4o wird durch die Fixierelemente 2' an der oberen Platte 17o fixiert. Ein zweites (unteres) Substrat 4u wird durch die Fixierelemente 2' an der unteren Platte 17u fixiert.

Erste Diagramme in der Figur 1 oberhalb und unterhalb des Bonders 13 stellen eine Ist-Krümmung 14u, 14o der Substrate 4u, 4o und/oder der Platten 17u, 17o sowie eine Soll-Krümmung 15u, 15o der Substrate 4u, 4o und/oder der Platten 17u, 17o als Funktion der x-Position dar. Neben den ersten Diagrammen sind zweite Diagramme in Figur 1 gezeigt, die einen Druck p_{1'}, der über die als Leitungen ausgebildeten Fixierelementverbindungen 6' abfällt und die Substrate 4u, 4o an den Platten 17u, 17o fixiert, darstellen. In der Darstellung existiert nur ein, insbesondere als kreisförmige Nut ausgeführtes, Fixierelement 2' an jeder Aufnahmeeinrichtungen 17u, 17o. Die dritten Diagramme zeigen schließlich den Druck p₁, der an der Peripherie der Platten 4u, 4o anliegt.

In der Figur sind zwei Arten von Begrenzungselementen erkennbar. An der unteren Aufnahmeeinrichtung 1u befinden sich erste Begrenzungselemente 19', die eine rein translatorische Verschiebung der erfindungsgemäßen Platte 17u einschränken. Denkbar ist beispielsweise, dass in einem Prozessschritt sämtliche Fixierungen 2 abgeschaltet werden und die untere Platte 17u frei auf einem Luftpolster schwebt, das durch ein Fluid, welches insbesondere aus dem Krümmungselement 5 austritt, erzeugt wird.

An der oberen Aufnahmeeinrichtung 1o befinden sich zweite Begrenzungselemente 19, die so geformt sind, dass sie ein Herabfallen der Platte 17o, insbesondere mit dem darauf fixierten Substrat 4o, verhindern.

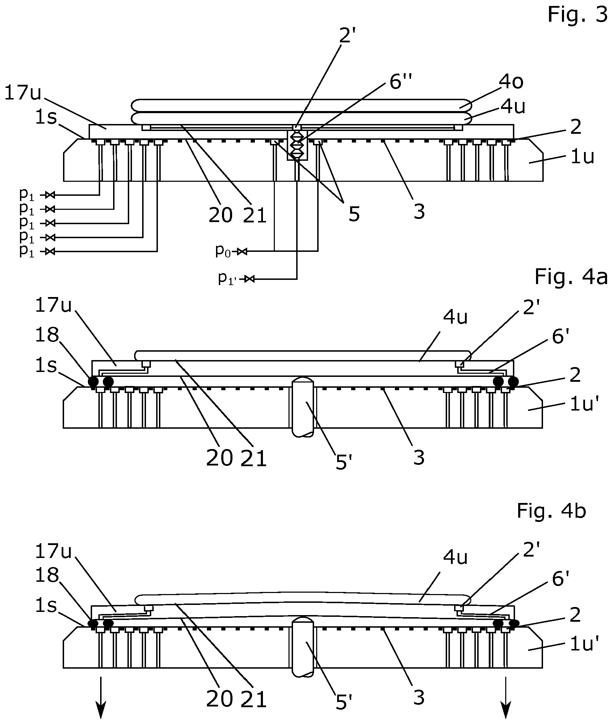

In einer bevorzugten Ausführungsform einer oberen Aufnahmeeinrichtung 1o gemäß Figur 3 erfolgt mit Hilfe einer, insbesondere dehnbaren Fixierelementverbindung 6" (in Figur 1 nicht eingezeichnet) eine von den ersten Fixierelementen 2 (mit Druck p₁ beaufschlagter Kanal) der Aufnahmeeinrichtung 1u unabhängige Ansteuerung der zweiten Fixierelemente 2'. Diese ist über eine Druckleitung mit einem Druck p_{1'} beaufschlagbar.

In der folgenden Figurenserie wird ein erfindungsgemäßer Prozessfluss anhand mehrerer Prozessschritte gemäß der oben beschriebenen ersten Ausführungsform eingehend dargestellt. Auf die Darstellung der Diagramme für Druck und Durchbiegungsverlauf wird der Übersichtlichkeit halber verzichtet. Die Soll- und Ist-krümmungen 15u, 15o, 14u, 14o werden in den weiteren Figuren nicht eingezeichnet, da keine Diagramme vorhanden sind. Deren schematischer Verlauf kann aus der Fig. 1 entnommen werden.

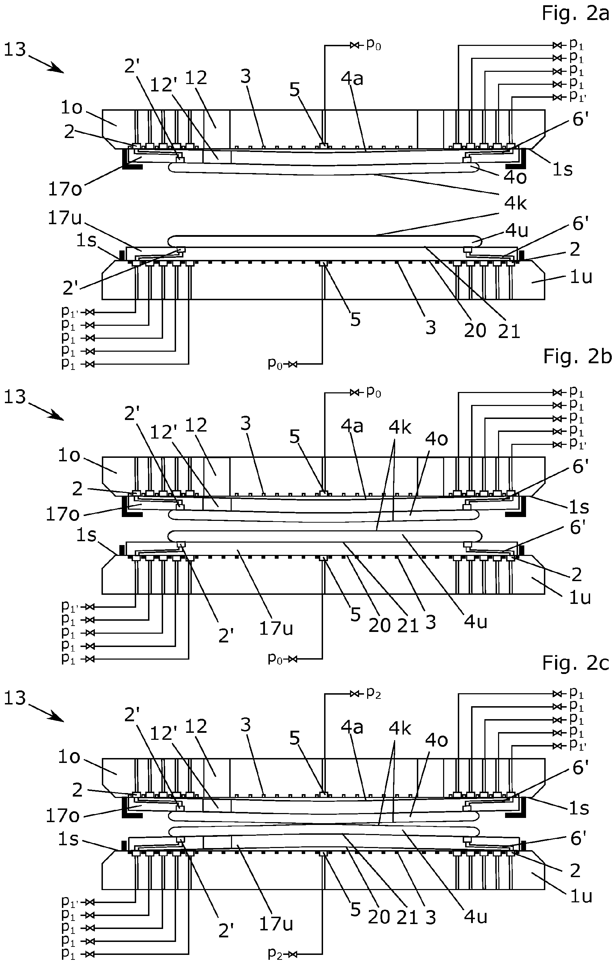

Die **Figur 2a** zeigt einen erfindungsgemäßen Bonder 13 zur Kontaktierung und zum Bonden von gegenüberliegend angeordneten Kontaktflächen 4k eines ersten/oberen Substrats 4o und eines zweiten/unteren Substrats 4u. Der Bonder 13 besteht aus einer unteren Aufnahmeeinrichtung 1u und einer oberen Aufnahmeeinrichtung 1o. Die Aufnahmeeinrichtungen 1u, 1o können insbesondere zur Aufnahme eines ersten/oberen Substrats 4o und/oder einer ersten/oberen Platte 17o und eines zweiten/unteren Substrats 4u und/oder einer zweiten/unteren Platte 17u ausgeführt sein, wobei die untere Aufnahmeeinrichtung 1u anders als die obere Aufnahmeeinrichtung 1o ausgeführt oder ausgestattet sein kann.

Die obere Aufnahmeeinrichtung 1o weist vorzugsweise Vermessungslöcher 12 auf, durch welche hindurch, insbesondere von einer Rückseite des Substrathalters 1o her, eine Vermessung der Platte 17o und/oder des Substrats 4o stattfinden kann. Wird das Substrat 4o vermessen, verfügt insbesondere auch die Platte 17o über entsprechende Vermessungslöcher 12'. Alternativ können Sensoren in den Vermessungslöchern 12, 12' angeordnet werden. Die Vermessungslöcher 12, 12' sind insbesondere zwischen den Krümmungsänderungsmitteln und den Fixiermitteln angeordnet. Alternativ oder zusätzlich kann der untere Substrathalter 1u und/oder die untere Platte 17u entsprechende Vermessungslöcher 12,12' aufweisen. Die Vermessungslöcher durchsetzen die Aufnahmeeinrichtung 1 und verlaufen insbesondere orthogonal zur Aufnahmefläche 1s. Vorzugsweise sind die Vermessungslöcher 12 in einem Abstand von 180° oder 120° zueinander an der Oberfläche verteilt angeordnet.

Die Aufnahmeeinrichtungen 1u, 1o besitzen eine Aufnahmefläche 1s, mit mehreren Fixierelementen 2 und Sensoren 3, 3'. Die Fixierelemente 2 werden über als Fluidleitungen ausgebildete Kanäle evakuiert und fixieren die Platten 17u, 17o. Die Abstandssensoren sind direkt am Krümmungsänderungsmittel 5 bis zu den Fixiermitteln verteilt angeordnet. Sie erstrecken sich somit über eine Teilfläche der Aufnahmefläche 1s.

Im Bereich der Fixiermittel sind als Drucksensoren ausgebildete Sensoren 3' angeordnet, mit welchen entlang der x-Position der Sensoren 3 zwischen den Platten 17u, 17o und den Aufnahmeeinrichtungen 1u, 1o die Drücke p₁ gemessen werden.

Das obere Substrat 4o weist eine, insbesondere auf Grund der Gravitation vorhandene, Ist-krümmung 14o auf, während das untere Substrat 1u plan aufliegt und daher im Sinne der vorliegenden Erfindung keine (in Realität eine verschwindend geringe) Ist-Krümmung 14u besitzt. Denkbar ist allerdings auch, dass die gravitativ eingestellte Ist-Krümmung 14o vernachlässigbar klein ist.

Die **Figur 2b** zeigt den Bonder 13 bei einem weiteren Prozessschritt. Die beiden Substrate 4u und 4o wurden durch eine Relativbewegung der beiden Substrathalter 1u, 1o aneinander angenähert. Ansonsten hat sich gegenüber der Situation gemäß Figur 2a nichts geändert.

Die **Figur 2c** zeigt den Bonder 13 bei einem weiteren Prozessschritt. Durch die Verwendung der Krümmungselemente 5, im gezeigten Fall eine Gasaustrittsöffnung, durch die ein Gas mit einem Druck p2 strömt, werden die beiden Platten 17u, 17o und damit die Substrate 1u, 1o in eine Soll-Krümmung gebracht, wobei vorzugsweise eine Regelung des Drucks mittels der Abstandssensoren erfolgt. Für die Steuerung/Regelung können auch die Drücke der Fixierelemente 2 verwendet werden, so dass diese auch Aufgaben der Krümmungsmittel 5, 5' oder Krümmungsänderungsmittel 5, 5' übernehmen und somit im Sinne der Erfindung auch zu diesen zählen können. Die Druckwerte sind insbesondere kontinuierlich und/oder stetig, vorzugsweise in Zonen separat, steuerbar/regelbar.

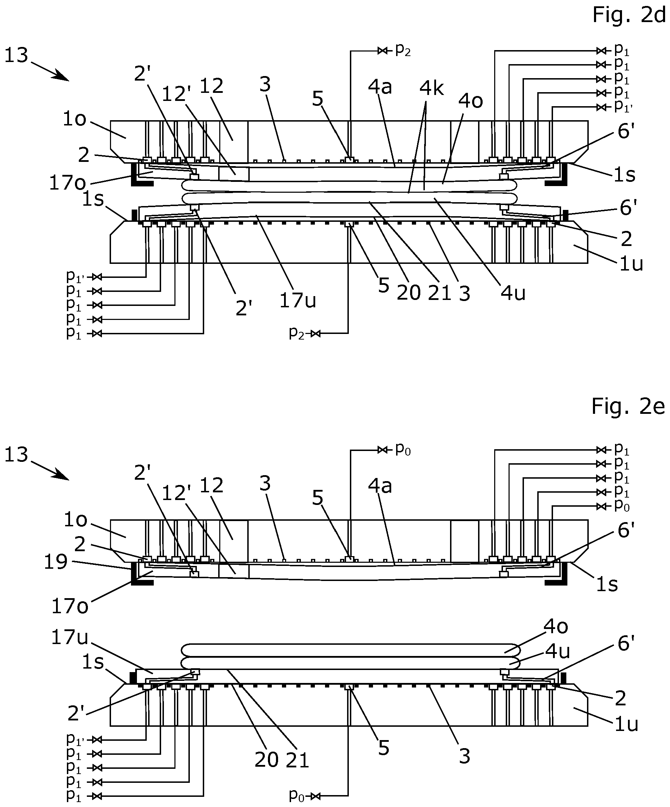

Die **Figur 2d** zeigt den Bonder 13 bei einem weiteren Prozessschritt. Die beiden Substrate 4u, 4o bilden durch die Annäherung der Substrate 4u, 4o eine Bondwelle, die sich radial nach außen ausbreitet, wobei sich die Krümmung der Substrate 4u, 4o kontinuierlich ändert (Krümmungsänderungsmittel). Dabei wird die Krümmungsänderung der unteren und/oder oberen Platte 17u,17o bzw. des unteren und/oder oberen Substrats 1u, 1o kontinuierlich mittels der Abstandssensoren überwacht und falls nötig durch das Krümmungselement 5 und/oder die Fixierelemente 2 so korrigiert, dass die jeweils erwünschte beziehungsweise eingestellte Soll-Krümmung erreicht wird (Krümmungsänderungsmittel). Wichtige Parameter stellen die Krümmungsradien R1 der oberen Platte 17o bzw. des oberen Substrats 4o und R2 der unteren Platte 17u bzw. des unteren Substrats 4u im Punkt der Bondwelle dar.

Die Drücke von vier inneren umfänglichen Reihen von Fixierelementen 2 werden bei der oberen Aufnahmeeinrichtung 1o und der unteren Aufnahmeeinrichtung 1u gleichzeitig auf p0 reduziert. Hierdurch verlieren die Substrate 1u, 1o oder die Platten 17u, 17o die Fixierung zur Aufnahmefläche 1o, insbesondere kontinuierlich von innen nach außen, wodurch sich der Druck p2 aus dem Krümmungselement 5 weiter ausbreiten kann.

Dadurch, dass die Steuerung die Krümmungen und Krümmungsänderungen der Substrate berücksichtigt, werden run-out-Fehler minimiert. Insbesondere werden, im Gegensatz zum Stand der Technik, "run-out" Fehler weiter minimiert, da das System Platte-Substrat einen höheren Biegewiderstand aufweist und das Substrat damit stabiler mit dem gegenüberliegenden Substrat bondet.

Die **Figur 2e** zeigt den Bonder 13 bei einem weiteren Prozessschritt. Die beiden Substrate 1u, 1o sind kontrolliert miteinander verbondet worden, indem der Druck der äußersten Reihe der Fixierelemente 2 der oberen Aufnahmeeinrichtung 1o auf p0 reduziert wurde. Insbesondere wurde die obere Platte 17o an der oberen Aufnahmeeinrichtung 1o belassen. Denkbar ist auch, dass die obere Platte 17o auf dem oberen Substrat 4o verbleibt. In diesem Fall dürften dann keine Begrenzungselemente 19 vorhanden sein.

In den weiteren Bildern werden weitere erfindungsgemäße Ausführungsformen der Aufnahmeeinrichtung dargestellt.

Die **Figur 3** zeigt eine verbesserte und bevorzugtere erfindungsgemäße Ausführungsform einer Aufnahmeeinrichtung 1u und einer Platte 17u, in der die Fixierung über eine, insbesondere als Balg oder Lippe konstruierte, Fixierelementverbindung 6" von der Aufnahmeeinrichtung 1u auf die Platte 17u übertragen wird. Die Fixierelementvorrichtung 6" ist insbesondere dehnbar, ohne die Fixierung eines Substrats 4u zur Platte 17u zu unterbrechen. Im Falle einer elektrostatischen Fixierung könnte es sich bei der Fixierelementverbindung 6" beispielsweise um Drehte handeln, welche das Potential zwischen der Aufnahmeeinrichtung 1u und der Platte 17u aufrechterhalten. Im Fall der dargestellten Vakuumfixierung handelt es sich bei der Fixierelementverbindung 6" um einen dehnbaren, insbesondere möglichst vakuumdichten Balg. Ist die Fixierelementverbindung 6" insbesondere zentrisch gelagert, befinden sich mögliche Krümmungselemente 5 seitlich von der Fixierelementverbindung 6".

Die **Figur 4a** zeigt eine Aufnahmeeinrichtung 1u', die ähnlich der Aufnahmeeinrichtung 1u aufgebaut ist, in einem ersten erfindungsgemäßen Prozessschritt. Ein Unterscheidungsmerkmal stellen die, auf der Aufnahmeeinrichtung 1u' insbesondere ringförmig angeordneten, Dichtringe 18 dar. Auf den Dichtringen 18 wird die Platte 17u gelagert.

Als Krümmungselement 5' ist bei dieser Ausführungsform ein Stift im Zentrum der Aufnahmeeinrichtung 1u' angeordnet. Der Stift durchsetzt die Aufnahmeeinrichtung 1u' im Zentrum und ist relativ zu diesem in einer z-Richtung beweglich. Zu einem ersten Zeitpunkt wird die Platte 17u mit dem Substrat 4u auf die Spitze des bereits angehobenen Krümmungselements 5' gelegt. Zum gleichen Zeitpunkt liegt die Platte noch auf unverformten Dichtringen 18. Die Platte 17u ist im Wesentlichen noch nicht gekrümmt.

Die **Figur 4b** zeigt die Aufnahmeeinrichtung 1u' in einem zweiten Prozessschritt. Durch das Einschalten des Vakuums entlang einer Vakuumstrecke (Kanäle, Fixierelemente 2, Fixierelementverbindungen 6', 6", Fixierelemente 2') wird die Platte 17u am Rand nach unten gezogen. Hierdurch werden die leicht verformbaren, elastischen Dichtringe 18 verformt und dichten die Platte gegenüber der Aufnahmeeinrichtung 1u ab. Beim erfindungsgemäßen Bondprozess wird nach der Kontaktierung des Substrats 4u mit dem Substrat 4o (nicht eingezeichnet) die Vakuumstrecke wieder geflutet und erlaubt damit einen verbesserten und optimierten Bondvorgang des Substrats 4u.

Die Ausführungsform der Figuren 3a, 3b kann als kinematische Umkehrung zu den Ausführungsformen aus den Figuren 1-2e angesehen werden. Insbesondere wird diese Ausführungsform dadurch charakterisiert, dass die Platte 17u durch die Erzeugung eines, insbesondere an der Peripherie angreifenden, Vakuums auch an der Peripherie nach unten gezogen wird, während in vorhergehenden Ausführungsformen beschrieben wurde, wie die Kraftaufbringung durch das Krümmungselement 5 dazu führt, dass die Platte 17u im Bereich des Krümmungselements 5 durch Verteilung des durch das Krümmungselement 5 einströmenden Fluids verformt wird.

### Bezugszeichenliste

- 1o: obere Aufnahmeeinrichtung
- 1u, 1u': untere Aufnahmeeinrichtung
- 1s: Aufnahmefläche
- 2, 2': Fixierelemente
- 3: Sensoren
- 4o: erstes/oberes Substrat
- 4u: zweites/unteres Substrat
- 4a: Substrataufnahmefläche
- 4k: Kontaktflächen
- 5, 5': Krümmungselement
- 6',6": Fixierelementverbindung
- 12: Vermessungslöcher
- 13: Bonder
- 14u, 14o: Ist-Krümmung
- 15u, 15o: Soll-Krümmung
- 16u, 16o: Druckverlauf
- 17o: Obere Platte
- 17u: Untere Platte
- 18: Dichtring
- 19, 19': Begrenzungselement
- 20: erste Plattenseite
- 21: zweite Plattenseite
- p₁, p_{1'}: Druck

## Patentansprüche

1. Verfahren zum Bonden eines ersten Substrats (4o) mit einem zweiten Substrat (4u) an einander zugewandten Kontaktflächen (4k) der Substrate (4o, 4u), wobei das erste Substrat (4o) auf einer ersten Aufnahmeeinrichtung (1o) und das zweite Substrat (4u) auf einer zweiten Aufnahmeeinrichtung (1u) mit einer Platte (17u) aufgenommen werden, und wobei die Platte (17u) zwischen dem zweiten Substrat (4u) und der zweiten Aufnahmeeinrichtung (1u) angeordnet ist, und wobei das zweite Substrat (4u) mit der Platte (17u) vor und/oder während des Bondens gegenüber der zweiten Aufnahmeeinrichtung (1u) verformt wird
**dadurch gekennzeichnet, dass** die Verformung mittels eines die Platte (17u) beaufschlagenden Krümmungsmittels (5. 5') eingestellt und/oder gesteuert wird und die Verformung des zweiten Substrats (4u) und/oder der Platte (17u) durch Krümmungsmessmittel erfasst wird.

2. Verfahren gemäß Anspruch 1, bei dem zwischen dem ersten Substrat (4o) und der ersten Aufnahmeeinrichtung (1o) eine weitere Platte (17o) angeordnet ist, wobei das erste Substrat (4o) mit der weiteren Platte (17o) vor und/oder während des Bondens gegenüber der ersten Aufnahmeeinrichtung (1o) verformt wird.

3. Verfahren nach einem der vorhergehenden Ansprüche, bei dem die Verformung vor einer Kontaktierung der Kontaktflächen (4k) spiegelsymmetrisch und/oder konzentrisch zu den Kontaktflächen (4k) eingestellt und/oder gesteuert wird.

4. Verfahren nach einem der vorhergehenden Ansprüche, bei dem wenigstens eine der Verformungen durch Fluiddruckbeaufschlagung eingestellt und/oder gesteuert wird.

5. Verfahren nach einem der vorhergehenden Ansprüche, bei dem wenigstens eine der Platten (17u, 17o) durch, insbesondere ringförmig, vorzugsweise kreisringförmig, am Umfang der Aufnahmeeinrichtungen (1u, 1o), insbesondere ausschließlich im Bereich des Umfangsrandes der Platte (17o, 17u), angeordnete erste Fixiermittel (2) fixiert wird.

6. Verfahren nach Anspruch 5, bei dem wenigstens eines der Substrate (4u, 4o) durch, insbesondere mit den ersten Fixiermitteln (2) der Aufnahmeeinrichtung verbundene, vorzugsweise gleichartige, zweite Fixiermittel (2') der Platte (17u, 17o) fixiert wird.

7. Verfahren nach einem der vorhergehenden Ansprüche, bei dem die Krümmungsmessmittel Sensoren (3), vorzugsweise Abstandssensoren, sind.

8. Vorrichtung zum Bonden eines ersten Substrats (4o) mit einem zweiten Substrat (4u) an einander zugewandten Kontaktflächen (4k) der Substrate (4o, 4u) mit
einer ersten Aufnahmeeinrichtung (1o) zur Aufnahme des ersten Substrats (4o) und einer zweiten Aufnahmeeinrichtung (1u) mit einer Platte (17u) zur Aufnahme des zweiten Substrats (4u), wobei die Platte (17u) zwischen dem zweiten Substrat (4u) und der zweiten Aufnahmeeinrichtung (1u) angeordnet ist,
und wobei Krümmungsänderungsmittel zur Verformung der Platte (17u) mit dem zweiten Substrat (4u) gegenüber der zweiten Aufnahmeeinrichtung (1u) während des Bondens steuerbar sind,
**dadurch gekennzeichnet, dass**
die zweite Aufnahmeeinrichtung (lu) Krümmungsmittel (5. 5') zur Einstellung und/oder Steuerung der Verformung aufweist und dass Krümmungsmessmittel zur Erfassung der Verformung vorgesehen sind.

9. Vorrichtung nach Anspruch 8, bei der zwischen dem ersten Substrat (4o) und der ersten Aufnahmeeinrichtung (1o) eine weitere Platte (17o) angeordnet ist, wobei das erste Substrat (4o) mit der weiteren Platte (17o) vor und/oder während des Bondens gegenüber der ersten Aufnahmeeinrichtung (1o) verformbar ausgebildet ist.

10. Vorrichtung nach Anspruch 8 oder 9, bei der die Krümmungsmittel mechanisch sind.

11. Vorrichtung nach Anspruch 8 oder 9, bei der die erste Aufnahmeeinrichtung (1o) und/oder die zweite Aufnahmeeinrichtung (1u), insbesondere ringförmig angeordnete, erste Fixiermittel (2) zur Fixierung der Platte (17o, 17u) aufweisen.

12. Vorrichtung nach Anspruch 11, bei der wenigstens eine der Platten, insbesondere mit den ersten Fixiermitteln (2) der Aufnahmeeinrichtung (1o, 1u) verbundene, vorzugsweise gleichartige, zweite Fixiermittel (2') zur Fixierung der Substrate (4u, 4o) aufweist.

13. Vorrichtung nach wenigstens einem der Ansprüche 8 bis 12, bei der wenigstens eine der Platten (17o, 17u) einen E-Modul zwischen 0.01 GPa und 1100 GPa, vorzugsweise zwischen 0.1 GPa und 800 GPa, noch bevorzugter zwischen 1 GPa und 600 GPa, am bevorzugtesten zwischen 10 GPa und 500 GPa, am allerbevorzugtesten zwischen 100 GPa und 450 GPa aufweist.

14. Vorrichtung nach wenigstens einem der Ansprüche 9 bis 13, bei der die Krümmungsmessmittel Sensoren, vorzugsweise Abstandssensoren, sind.

## Claims

1. A method for bonding a first substrate (4o) to a second substrate (4u) on mutually facing contact surfaces (4k) of the substrates (4o, 4u), the first substrate (4o) being mounted on a first chuck (1o) and the second substrate (4u) being mounted on a second chuck (1u) with a plate (17u), and the plate (17u) being arranged between the second substrate (4u) and the second chuck (1u), and
the second substrate (4u) with the plate (17u) is deformed with respect to the second chuck (1u) before and/or during the bonding **characterized in that** the deformation is set and/or controlled by means of a bending means (5, 5') loading the plate (17u) and the deformation of the second substrate (4u) and/or the plate (17u) is detected by curvature measuring means.

2. The method according to Claim 1, in which a further plate (17o) is arranged between the first substrate (4o) and the first chuck (1o), wherein the first substrate (4o) with the further plate (17o) is deformed with respect to the first chuck (1o) before and/or during the bonding.

3. The method according to one of the preceding claims, in which the deformation is set and/or controlled prior to a contacting of the contact surfaces (4k) mirror symmetrically and/or concentrically to the contact surfaces (4k).

4. The method according to one of the preceding claims, in which at least one of the deformations is set and/or controlled by means of fluid-pressure loading.

5. The method according to one of the preceding claims, in which at least one of the plates (17u, 17o) is fixed by first fixing means (2) arranged in particular annularly, preferably in a ring-shaped manner, on the circumference of the chucks (1u, 1o), particularly exclusively in the region of the circumferential edge of the plate (17o, 17u).

6. The method according to Claim 5, in which at least one of the substrates (4u, 4o) is fixed by second fixing means (2'), preferably of the same type, of the plate (17u, 17o), connected in particular to the first fixing means (2) of the chuck.

7. The method according to one of the preceding claims, in which the curvature measuring means are sensors (3), preferably distance sensors.

8. A device for bonding a first substrate (4o) to a second substrate (4u) at mutually facing contact surfaces (4k) of the substrates (4o, 4u), having
a first chuck (1o) for mounting the first substrate (4o) and a second chuck (lu) with a plate (17u) for mounting the second substrate (4u),
the plate (17u) being arranged between the second substrate (4u) and the second chuck (1u)
and it being possible to control bend-changing means for deforming the plate (17u) with the second substrate (4u) with respect to the second chuck (1u) during the bonding,
**characterized in that**
the second chuck (1u) has bending means (5, 5') for setting and/or controlling the deformation and **in that** curvature measuring means are provided for detecting the deformation.

9. The device according to Claim 8, in which a further plate (17o) is arranged between the first substrate (4o) and the first chuck (1o), wherein the first substrate (4o) with the further plate (17o) is constructed in a deformable manner with respect to the first chuck (1o) before and/or during the bonding.

10. The device according to Claim 8 or 9, in which the bending means are mechanical.

11. The device according to Claim 8 or 9, in which the first chuck (1o) and/or the second chuck (1u) have, in particular annularly arranged, first fixing means (2) for fixing the plate (17o, 17u).

12. The device according to Claim 11, in which at least one of the plates has second fixing means (2'), preferably of the same type, connected to the first fixing means (2) of the chuck (1o, 1u) in particular, for fixing the substrates (4u, 4o).

13. The device according to at least one of Claims 8 to 12, in which at least one of the plates (17o, 17u) has a Young's modulus of between 0.01 GPa and 1100 GPa, preferably between 0.1 GPa and 800 GPa, more preferably between 1 GPa and 600 GPa, most preferably between 10 GPa and 500 GPa, most preferably of all between 100 GPa and 450 GPa.

14. The device according to at least one of Claims 9 to 13, in which the curvature measuring means are sensors, preferably distance sensors.

## Revendications

1. Procédé destiné à la liaison d'un premier substrat (4o) à un second substrat (4u) sur des surfaces de contact (4k) tournées l'une vers l'autre des substrats (4o, 4u), dans lequel le premier substrat (4o) est reçu sur un premier dispositif de réception (1o) et le second substrat (4u) est reçu sur un second dispositif de réception (1u) avec une plaque (17u), et dans lequel la plaque (17u) est disposée entre le second substrat (4u) et le second dispositif de réception (1u), et dans lequel
le second substrat (4u) avec la plaque (17u) est déformé par rapport au second dispositif de réception (1u) avant et/ou pendant la liaison,
**caractérisé en ce que** la déformation est réglée et/ou commandée au moyen d'un moyen d'un moyen d'inflexion (5, 5') sollicitant la plaque (17u) et la déformation du second substrat (4u) et/ou de la plaque (17u) est détectée par des moyens de mesure d'inflexion.

2. Procédé selon la revendication 1, dans lequel une plaque supplémentaire (17o) est disposée entre le premier substrat (4o) et le premier dispositif de réception (1o), dans lequel le premier substrat (4o) avec la plaque supplémentaire (17o) est déformé avant et/ou pendant la liaison, par rapport au premier dispositif de réception (1o).

3. Procédé selon l'une des revendications précédentes, dans lequel la déformation est réglée et/ou commandée en symétrie de miroir et/ou de manière concentrique aux surfaces de contact (4k), avant une mise en contact des surfaces de contact (4k).

4. Procédé selon l'une des revendications précédentes, dans lequel au moins une des déformations est réglée et/ou commandée par application de pression fluidique.

5. Procédé selon l'une des revendications précédentes, dans lequel au moins une des plaques (17u, 17o) est fixée par des premiers moyens de fixation (2) disposés, en particulier de façon annulaire, en particulier en formant un cercle, sur le pourtour des dispositifs de réception (1u, 1o), en particulier exclusivement au niveau du bord périphérique de la plaque (17u, 17o).

6. Procédé selon la revendication 5, dans lequel au moins un des substrats (4u, 4o) est fixé par des seconds moyens de fixation (2') de la plaque (17u, 17o), de préférence similaires, reliés en particulier aux premiers moyens de fixation (2) du dispositif de réception.

7. Procédé selon l'une des revendications précédentes, dans lequel les moyens de mesure d'inflexion sont des capteurs (3), de préférence des capteurs de distance.

8. Dispositif destiné à la liaison d'un premier substrat (4o) à un second substrat (4u) sur des surfaces de contact (4k) tournées l'une vers l'autre des substrats (4o, 4u), comprenant :
un premier dispositif de réception (1o) pour recevoir le premier substrat (4o) et un second dispositif de réception (1u) avec une plaque (17u) pour recevoir le second substrat (4u),
dans lequel la plaque (17u) est disposée entre le second substrat (4u) et le second dispositif de réception (1u),
et dans lequel des moyens de modification d'inflexion pour la déformation de la plaque (17u) avec le second substrat (4u) par rapport au second dispositif de réception (1u) peuvent être commandés pendant la liaison,
**caractérisé en ce que**
le second dispositif de réception (1u) présente des moyens d'inflexion (5, 5') pour régler et/ou commander la déformation et que des moyens de mesure d'inflexion sont prévus pour détecter la déformation.

9. Dispositif selon la revendication 8, dans lequel une plaque supplémentaire (17o) est disposée entre le premier substrat (4o) et le premier dispositif de réception (1o), dans lequel le premier substrat (4o) avec la plaque supplémentaire (17o) peut être déformé avant et/ou pendant la liaison, par rapport au premier dispositif de réception (1o).

10. Dispositif selon la revendication 8 ou 9, dans lequel les moyens d'inflexion sont mécaniques.

11. Dispositif selon la revendication 8 ou 9, dans lequel le premier dispositif de réception (1o) et/ou le second dispositif de réception (1u) présente(nt) des premiers moyens de fixation (2) disposés en particulier de façon annulaire pour fixer les plaques (17u, 17o).

12. Dispositif selon la revendication 11, dans lequel au moins une des plaques présente des seconds moyens de fixation (2'), de préférence similaires, reliés en particulier aux premiers moyens de fixation (2) du dispositif de réception (1o, 1u), pour fixer les substrats (4u, 4o)

13. Dispositif selon au moins l'une des revendications 8 à 12, dans lequel au moins une des plaques (17o, 17u) présente un module d'élasticité entre 0,01 GPa et 1100 GPa, de préférence entre 0,1 GPa et 800 GPa, plus encore de préférence entre 1 GPa et 600 GPa, de manière la plus préférée entre 10 GPa et 500 GPa, de la manière préférée entre toutes entre 100 GPa et 450 GPa.

14. Dispositif selon au moins l'une des revendications 9 à 13, dans lequel les moyens de mesure d'inflexion sont des capteurs, de préférence des capteurs de distance.
